(19)

**Europäisches Patentamt**
**European Patent Office**
**Office européen des brevets**

(11) **EP 4 642 204 A1**

(12) **EUROPEAN PATENT APPLICATION**
published in accordance with Art. 153(4) EPC

(43) Date of publication:
**29.10.2025 Bulletin 2025/44**

(21) Application number: **23953430.8**

(22) Date of filing: **26.09.2023**

(51) International Patent Classification (IPC):
***H10K 59/131*** (2023.01)

(52) Cooperative Patent Classification (CPC):
**H10K 59/131**

(86) International application number:
**PCT/CN2023/121714**

(87) International publication number:
**WO 2025/065272 (03.04.2025 Gazette 2025/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
• **Boe Technology Group Co., Ltd.**
**Beijing 100015 (CN)**
• **Chongqing Boe Display Technology Co., Ltd.**
**Chongqing 400714 (CN)**

(72) Inventors:
• **ZHANG, Shouqiang**
**Beijing 100176 (CN)**
• **QIU, Yuanyou**
**Beijing 100176 (CN)**

• **ZHANG, Runxin**
**Beijing 100176 (CN)**
• **ZENG, Chao**
**Beijing 100176 (CN)**
• **WENG, Hongtao**
**Beijing 100176 (CN)**
• **WANG, Rui**
**Beijing 100176 (CN)**
• **DING, Xiang**
**Beijing 100176 (CN)**
• **YANG, Ni**
**Beijing 100176 (CN)**
• **LIU, Yifan**
**Beijing 100176 (CN)**

(74) Representative: **Durán-Corretjer, S.L.P.**
**Còrsega, 329**
**(Paseo de Gracia/Diagonal)**
**08037 Barcelona (ES)**

(54) **DISPLAY SUBSTRATE AND DISPLAY DEVICE**

(57)    A display substrate and a display device, the display substrate comprising a base (101), and a second power supply line (VSS) and at least one second power supply connection line (VSSL) which are disposed on one side of the base (101), wherein the base comprises a display area (100) and a frame area (300), on a plane parallel to the display substrate, the frame area (300) being located around the display area (100); the second power supply line (VSS) is arranged in the frame area (300) and at least located on two opposite sides of the display area (100); and the at least one second power supply connection line (VSSL) is located in the display area (100) and extends to the two opposite sides of the display area (100), and is electrically connected to the second power supply line (VSSL) located on at least one side of the display area (100).

FIG. 5a

EP 4 642 204 A1

**Description**

Technical Field

The present disclosure relates to, but is not limited to, the field of display technologies, and particularly to a display substrate and a display device.

Background

An Organic Light Emitting Diode (OLED for short) and a Quantum dot Light Emitting Diode (QLED for short) are active light emitting display devices and have advantages such as self-luminescence, wide viewing angle, high contrast ratio, low power consumption, very high response speed, lightness and thinness, flexibility, and low cost. With constant development of display technologies, a flexible display device (Flexible Display) in which an OLED or a QLED is used as a light emitting device and signal control is performed through a Thin Film Transistor (TFT for short) has become a mainstream product in the field of display at present.

Summary

The following is a summary of subject matter described herein in detail. This summary is not intended to limit the protection scope of claims.

In a first aspect, an embodiment of the present disclosure provides a display substrate including a base substrate, and second power supply lines and at least one second power supply connection line disposed on a side of the base substrate, wherein the base substrate includes a display area and a bezel area, the bezel area is located around the display area on a plane parallel to the display substrate, and the second power supply lines are disposed in the bezel area and at least on opposite sides of the display area; the at least one second power supply connection line is located in the display area and extends to the opposite sides of the display area, and is electrically connected to a second power supply line located on at least one side of the display area.

In an exemplary implementation, the display substrate further includes second power supply adapt electrodes and second power supply adapt lines located in the bezel area, wherein on the plane parallel to the display substrate, the second power supply adapt lines are located between the display area and the second power supply lines, the at least one second power supply connection line is connected to the second power supply adapt lines, and in a direction perpendicular to the plane on which the display substrate is located, the second power supply adapt electrodes are located on a side of the at least one second power supply connection line and the second power supply lines away from the base substrate, the second power supply lines and the second power supply adapt lines are electrically connected through the second power supply adapt electrodes.

In an exemplary implementation, orthographic projections of the second power supply adapt electrodes on the base substrate are at least partially overlapped with orthographic projections of the second power supply adapt lines and the second power supply lines on the base substrate, and the second power supply adapt electrodes are electrically connected to the second power supply lines and the second power supply adapt lines through vias, respectively.

In an exemplary implementation, the bezel area includes a first bezel region and a second bezel region located on two sides of the display area in a second direction, and a third bezel region and a fourth bezel region located on two sides of the display area in a first direction, wherein the second bezel region is provided with at least one drive signal connection line, the third bezel region and the fourth bezel region are respectively provided with at least one type of drive signal line, and drive signal lines of a same type located in the third bezel region and the fourth bezel region are electrically connected through one of the at least one drive signal connection line, and on the plane parallel to the display substrate, the at least one drive signal connection line is located between the second power supply lines and the second power supply adapt lines, the drive signal lines are located between the second power supply lines and the display area, and the first direction intersects with the second direction.

In an exemplary implementation, the bezel area further includes a bonding region, and on the plane parallel to the display substrate, the bonding region is located on one side of the display area, the second power supply lines are at least located in the bonding region and on a side of the display area away from the bonding region, and the at least one second power supply connection line extends in a direction from the bonding region to the display area; the bonding region is located in the first bezel region, and the second power supply adapt electrodes and the second power supply adapt lines are located in the first bezel region and the second bezel region.

In an exemplary implementation, the display substrate further includes a first power supply signal supply line disposed in the bezel area and located around the display area in a direction parallel to the plane on which the display substrate is located, and in the first bezel region or the second bezel region, the first power supply signal supply line is located between the second power supply adapt lines and the display area, and in the third bezel region or the fourth bezel region, the first power supply signal supply line is located between the drive signal lines and the display area.

In an exemplary implementation, the display substrate further includes a plurality of first power supply connection lines and a plurality of first power supply lines located in the display area, wherein the display area is further provided with a plurality of sub-pixels arranged in an array, the plurality of first power supply connection lines extend in the first direction and are arranged at intervals in the second direction, and the plurality of first power supply lines extend in the second direction and are arranged at intervals in the first direction;

two ends of the first power supply connection lines are electrically connected to the first power supply signal supply line located in the third bezel and the fourth bezel, respectively, and middle parts of the first power supply connection lines are electrically connected to at least one row of sub-pixels; in the direction perpendicular to the plane on which the display substrate is located, the first power supply lines are located on a side of the first power supply connection lines and the first power supply signal supply line away from the base substrate, middle parts of the first power supply lines are electrically connected to the plurality of first power supply lines, and two ends of the first power supply lines are electrically connected to the first power supply signal supply line located in the first bezel region and the second bezel region, respectively.

In an exemplary implementation, in the second direction, a size of the first power supply signal supply line and a size of a second power supply line are both larger than a size of a second power supply adapt line.

In an exemplary implementation, the display substrate further includes an anode conductive layer and a cathode layer, wherein in the direction perpendicular to the plane on which the display substrate is located, the cathode layer is located on a side of the anode conductive layer away from the base substrate; the second power supply adapt electrodes are located in the anode conductive layer, and orthographic projections of the second power supply adapt electrodes on the base substrate are at least partially overlapped with an orthographic projection of the cathode layer on the base substrate, and the second power supply adapt electrodes are electrically connected to the cathode layer.

In an exemplary implementation, a plurality of second power supply connection lines are provided, the display area includes a plurality of sub-pixels arranged in an array, the plurality of second power supply connection lines are arranged in a row direction and extend in a column direction, at least one of the second power supply connection lines is disposed between two adjacent columns of sub-pixels, and the row direction intersects with the column direction on the plane parallel to the display substrate.

In an exemplary implementation, the display area further includes a plurality of initial signal lines and a plurality of initial signal connection lines, the plurality of initial signal lines are configured to be electrically connected to a plurality of rows of sub-pixels respectively, and the initial signal connection lines are configured to be electrically connected to at least some of the initial signal lines; in a direction parallel to the plane on which the display substrate is located, the plurality of initial signal lines extend in the row direction and are arranged at intervals in the column direction, and the plurality of initial signal connection lines extend in the column direction and are arranged at intervals in the row direction, and in a direction perpendicular to the plane on which the display substrate is located, the plurality of initial signal connection lines and the plurality of initial signal lines are located in different conductive layers.

In an exemplary implementation, the plurality of initial signal lines include a plurality of first initial signal lines and a plurality of second initial signal lines, and at least some of the sub-pixels include a plurality of transistors, the plurality of transistors include at least first transistors and seventh transistors; the plurality of first initial signal lines are configured to be electrically connected to the first transistors in the plurality of rows of sub-pixels respectively, and the plurality of second initial signal lines are configured to be electrically connected to the seventh transistors in the plurality of rows of sub-pixels respectively; and

the plurality of initial signal connection lines include a plurality of first initial signal connection lines and a plurality of second initial signal connection lines; the first initial signal connection lines are configured to be electrically connected to the plurality of first initial signal lines, and the second initial signal connection lines are configured to be electrically connected to the plurality of second initial signal lines.

In an exemplary implementation, the display substrate includes a semiconductor layer, a second conductive layer, a third conductive layer, and a fourth conductive layer sequentially disposed on the base substrate in the direction perpendicular to the plane on which the display substrate is located, and the plurality of initial signal lines are disposed in one of the semiconductor layer, the second conductive layer, and the third conductive layer; and the plurality of initial signal connection lines are disposed in the fourth conductive layer.

In an exemplary implementation, the plurality of sub-pixels form a plurality of pixel units arranged in an array, at least some of the pixel units include at least three sub-pixels sequentially arranged in the row direction, and a second power supply connection line, a first initial signal line, and a second initial signal line are disposed between two adjacent columns of pixel units.

In an exemplary implementation, the second power supply connection line, the first initial signal connection line, and the second initial signal connection line are arranged periodically in the row first direction.

In an exemplary implementation, in one period, the second power supply connection line, the first initial signal connection line, and the second initial signal connection line are arranged periodically in the row first direction, wherein the second power supply connection line and the first initial signal connection line are spaced by R columns of pixel units, the first initial signal connection line and the second initial signal connection line are spaced by R columns of pixel units, and the second initial signal connection line and a second power supply connection line in an adjacent period by R columns of pixel units, where R is an integer greater than or equal to 1.

In an exemplary implementation, two first initial signal connection lines, two second initial signal connection lines and one second power supply connection line are included in one period, and in the row direction, the two first initial signal connection lines and the two second initial signal connection lines are located on two sides of the second power supply connection line, and on a same side of the second power supply connection line, the first initial signal connection line and the second initial signal connection line are arranged sequentially in the row direction; and

in a same period, the first initial signal connection line and an adjacent second initial signal connection line are spaced by R columns of pixel units, the second power supply connection line and an adjacent first initial signal connection line and an adjacent second initial signal connection line are spaced by R columns of pixel units, where R is an integer greater than or equal to 1.

In an exemplary implementation, the display substrate further includes a shield layer and a circuit structure layer disposed on the base substrate, and the shield layer is located between the base substrate and the circuit structure layer in the direction perpendicular to the plane on which the display substrate is located.

In an exemplary implementation, the display area is provided with a plurality of sub-pixels, at least some of the sub-pixels including first transistors to seventh transistors in the circuit structure layer and at least one shield structure in the shield layer, and each shield structure is disposed to shield a channel region of at least one of a first transistor to a seventh transistor in a same sub-pixel.

In an exemplary implementation, in the same sub-pixel, the shield layer includes one or more of a first shield structure to a seventh shield structure, an orthographic projection of the first shield structure on the base substrate is at least partially overlapped with an orthographic projection of the first transistor on the base substrate; an orthographic projection of a second shield structure on the base substrate is at least partially overlapped with an orthographic projection of a second transistor on the base substrate; an orthographic projection of a third shield structure on the base substrate is at least partially overlapped with an orthographic projection of a third transistor on the base substrate; an orthographic projection of a fourth shield structure on the base substrate is at least partially overlapped with an orthographic projection of a fourth transistor on the base substrate; an orthographic projection of a fifth shield structure on the base substrate is at least partially overlapped with an orthographic projection of a fifth transistor on the base substrate; an orthographic projection of a sixth shield structure on the base substrate is at least partially overlapped with an orthographic projection of a sixth transistor on the base substrate; and an orthographic projection of the seventh shield structure on the base substrate is at least partially overlapped with an orthographic projection of the seventh transistor on the base substrate.

In an exemplary implementation, the plurality of sub-pixels form a plurality of sub-pixel rows, the shield layer includes second shield structures and fourth shield structures, and in a same sub-pixel row, a second shield structure located in one sub-pixel and a fourth shield structure located in an adjacent sub-pixel are formed into an integral structure.

In an exemplary implementation, the plurality of sub-pixels form a plurality of sub-pixel rows, the shield layer includes third shield structures, and in a same sub-pixel row and in a row direction, a distance between two third shield structures located in two adjacent sub-pixels is greater than a size of a channel region of a fourth transistor.

In an exemplary implementation, the shield structures in the shield layer in a same sub-pixel are of an integral structure; the shield layers of the plurality of sub-pixels are connected to each other to form into an integral structure.

In an exemplary implementation, the display substrate further includes a first power supply signal supply line, wherein the first power supply signal supply line is disposed in the bezel area and located around the display area, and in the direction perpendicular to the plane on which the display substrate is located, the first power supply signal supply line is located on a side of the shield layer away from the base substrate, and shield layers of a plurality of sub-pixels located on a side of the display area close to the bezel area are electrically connected to the first power supply signal supply line.

In an exemplary implementation, the display substrate further includes shield adapt lines located at least on two sides of a group of opposite sides of the display area, and on the plane parallel to the display substrate, the shield adapt lines are located between the second power supply lines and the display area, the shield layers of a plurality of sub-pixels located on the side of the display area close to the bezel area are connected to the shield adapt lines, the first power supply signal supply line is electrically connected to the shield adapt lines through vias, and an orthographic projection of the first power supply signal supply line on the base substrate is at least partially overlapped with orthographic projections of the shield adapt lines on the base substrate.

In a second aspect, an embodiment of the present disclosure further provides a display device, including the display substrate according to any one of the embodiments described above.

Other aspects of the present disclosure may be comprehended after the drawings and the detailed descriptions are read and understood.

Brief Description of Drawings

Accompanying drawings are intended to provide further understanding of technical solutions of the present disclosure and form a part of the specification, and are used to explain the technical solutions of the present disclosure together with embodiments of the present disclosure, but do not form limitations on the technical solutions of the present disclosure. Shapes and sizes of each component in the drawings do not reflect actual scales, but are only intended to schematically illustrate contents of the present disclosure.

FIG. 1 is a schematic diagram of a structure of a display device.

FIG. 2 is a schematic diagram of a planar structure of a display substrate.

FIG. 3 illustrates a schematic diagram of a sectional structure of a display substrate.

FIG. 4 is an equivalent circuit diagram of a pixel drive circuit.

FIG. 5a shows a schematic diagram of a planar structure of a display substrate according to an exemplary embodiment of the present disclosure.

FIG. 5b is a schematic diagram of a planar structure of a display substrate according to an exemplary embodiment of the present disclosure.

FIG. 5c is a schematic diagram of a planar structure of a display substrate according to an exemplary embodiment of the present disclosure.

FIG. 5d is a schematic diagram of a planar structure of a display substrate according to an exemplary embodiment of the present disclosure.

FIG. 6a shows a schematic diagram of a structure of a display substrate according to an exemplary embodiment of the present disclosure.

FIG. 6b shows a schematic diagram of a structure of a display substrate according to an exemplary embodiment of the present disclosure.

FIG. 6c shows a schematic diagram of a structure of a display substrate according to an exemplary embodiment of the present disclosure.

FIG. 6d shows a schematic diagram of a structure of a display substrate according to an exemplary embodiment of the present disclosure.

FIG. 7a shows a schematic diagram of a structure of a display substrate according to an exemplary embodiment of the present disclosure.

FIG. 7b shows a schematic diagram of a structure of a display substrate according to an exemplary embodiment of the present disclosure.

FIG. 7c shows a schematic diagram of a structure of a display substrate according to an exemplary embodiment of the present disclosure.

FIG. 7d shows a schematic diagram of a structure of a display substrate according to an exemplary embodiment of the present disclosure.

FIG. 7e shows a schematic diagram of a structure of a display substrate according to an exemplary embodiment of the present disclosure.

FIG. 8a shows a schematic diagram of a planar structure of a display substrate according to an exemplary embodiment of the present disclosure.

FIG. 8b is a schematic diagram of a planar structure of a shield layer in FIG. 8a.

FIG. 8c shows a schematic diagram of a sectional structure of a display substrate according to an exemplary embodiment of the present disclosure.

FIG. 9 shows a schematic diagram of a display substrate according to an exemplary embodiment of the present disclosure after a pattern of a shield layer is formed.

FIG. 10a shows a schematic diagram of a display substrate according to an exemplary embodiment of the present disclosure after a pattern of a semiconductor layer is formed.

FIG. 10b shows a schematic diagram of a semiconductor layer in a display substrate according to an exemplary embodiment of the present disclosure.

FIG. 10c shows a schematic diagram of a semiconductor layer in a display substrate according to an exemplary embodiment of the present disclosure.

FIG. 11a shows a schematic diagram of a display substrate according to an exemplary embodiment of the present disclosure after a pattern of a first conductive layer is formed.

FIG. 11b shows a schematic diagram of a first conductive layer in a display substrate according to an exemplary embodiment of the present disclosure.

FIG. 12a shows a schematic diagram of a display substrate according to an exemplary embodiment of the present disclosure after a pattern of a second conductive layer is formed.

FIG. 12b shows a schematic diagram of a second conductive layer in a display substrate according to an exemplary embodiment of the present disclosure.

FIG. 13 shows a schematic diagram of a display substrate according to an exemplary embodiment of the present disclosure after a pattern of a fourth insulation layer is formed.

FIG. 14a shows a schematic diagram of a display substrate according to an exemplary embodiment of the present disclosure after a pattern of a third conductive layer is formed.

FIG. 14b shows a schematic diagram of a third conductive layer in a display substrate according to an exemplary embodiment of the present disclosure.

FIG. 14c shows a schematic diagram of a third conductive layer in a display substrate according to an exemplary embodiment of the present disclosure.

FIG. 15 shows a schematic diagram of a display substrate according to an exemplary embodiment of the present disclosure after a pattern of a first planarization layer is formed.

FIG. 16a shows a schematic diagram of a display substrate according to an exemplary embodiment of the present disclosure after a pattern of a fourth conductive layer is formed.

FIG. 16b shows a schematic diagram of a fourth conductive layer in a display substrate according to an exemplary embodiment of the present disclosure.

FIG. 16c shows a schematic diagram of a display substrate according to an exemplary embodiment of the present disclosure after a pattern of a fourth conductive layer is formed.

FIG. 16d shows a schematic diagram of a fourth conductive layer in a display substrate according to an exemplary embodiment of the present disclosure.

FIG. 16e shows a schematic diagram of a display substrate according to an exemplary embodiment of the present disclosure after a pattern of a fourth conductive layer is formed.

FIG. 17 shows a schematic diagram after a pattern of a second planarization layer is formed according to an exemplary embodiment of the present disclosure.

FIG. 18 shows a schematic diagram of a display substrate according to an exemplary embodiment of the present disclosure after a pattern of an anode conductive layer is formed.

FIG. 19 is a schematic diagram of a display substrate after a pattern of a pixel definition layer is formed according to an exemplary embodiment of the present disclosure.

FIG. 20 shows a schematic diagram of a third conductive layer in a display substrate according to an exemplary embodiment of the present disclosure.

FIG. 21 shows a schematic diagram of a third conductive layer in a display substrate according to an exemplary embodiment of the present disclosure.

FIG. 22 shows a schematic diagram after a pattern of a shield layer is formed according to an exemplary embodiment of the present disclosure.

FIG. 23a shows a schematic diagram after a pattern of a semiconductor layer is formed according to an exemplary embodiment of the present disclosure.

FIG. 23b shows a schematic diagram of a semiconductor layer in a display substrate according to an exemplary embodiment of the present disclosure.

FIG. 24a shows a schematic diagram of a display substrate according to an exemplary embodiment of the present disclosure after a pattern of a first conductive layer is formed.

FIG. 24b shows a schematic diagram of a first conductive layer in a display substrate according to an exemplary embodiment of the present disclosure.

FIG. 25a shows a schematic diagram of a display substrate according to an exemplary embodiment of the present disclosure after a pattern of a second conductive layer is formed.

FIG. 25b shows a schematic diagram of a second conductive layer in a display substrate according to an exemplary embodiment of the present disclosure.

FIG. 26 shows a schematic diagram of a display substrate according to an exemplary embodiment of the present disclosure after a pattern of a fourth insulation layer is formed.

FIG. 27a shows a schematic diagram of a display substrate according to an exemplary embodiment of the present disclosure after a pattern of a third conductive layer is formed.

FIG. 27b shows a schematic diagram of a third conductive layer in a display substrate according to an exemplary embodiment of the present disclosure.

FIG. 28 shows a schematic diagram of a display substrate according to an exemplary embodiment of the present disclosure after a pattern of a first planarization layer is formed.

FIG. 29a shows a schematic diagram of a display substrate according to an exemplary embodiment of the present disclosure after a pattern of a fourth conductive layer is formed.

FIG. 29b shows a schematic diagram of a fourth conductive layer in a display substrate according to an exemplary embodiment of the present disclosure.

Detailed Description

Embodiments of the present disclosure will be described in detail hereinafter with reference to the drawings. Implementations may be implemented in a plurality of different forms. Those of ordinary skills in the art can easily understand such a fact that implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict. In order to keep following description of the embodiments of the present disclosure clear and concise, detailed description of part of known functions and known components are omitted in the present disclosure. The drawings in the embodiments of the present disclosure relate only to the structures involved in the embodiments of the present disclosure, and other structures may be described with reference to conventional designs.

Scales of the drawings in the present disclosure may be used as a reference in actual processes, but are not limited thereto. For example, a thickness and a pitch of each film layer, and a width and a pitch of each signal line may be adjusted according to an actual situation. The drawings described in the present disclosure are only schematic diagrams of structures, and one implementation of the present disclosure is not limited to shapes or numerical values or the like shown in the drawings.

Ordinal numerals "first", "second", "third", etc., in the specification are set not to form limits in numbers but only to avoid confusion between constituent elements.

In the specification, for convenience, expressions "central", "above", "below", "front", "back", "vertical", "horizontal", "top", "bottom", "inside", "outside", etc., indicating directional or positional relationships are used to illustrate positional relationships between the constituent elements, not to indicate or imply that involved devices or elements are required to have specific orientations and be structured and operated with the specific orientations but only for ease and simplification of the description of the present specification, and thus should not be understood as limitations on the present disclosure. The positional relationships between the constituent elements may be changed as appropriate according to a direction which is used for describing each constituent element. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be fixed connection, or a detachable connection, or an integral connection; it may be a mechanical connection or an electrical connection; it may be a direct connection, or an indirect connection through middleware, or internal communication inside two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as the "source terminal" and the "drain terminal", are interchangeable in the specification. In an embodiment of the present disclosure, the gate electrode may be referred to as a control electrode.

In the specification, "electrical connection" includes connection of constituent elements through an element with a certain electrical action. An "element with a certain electrical action" is not particularly limited as long as electrical signals between the connected constituent elements may be sent and received. Examples of the "element with the certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive thin film" sometimes. Similarly, an "insulation film" may be replaced with an "insulation layer" sometimes.

Triangle, rectangle, trapezoid, pentagon, hexagon, etc. in this specification are not strictly defined, and they may be approximate triangle, rectangle, trapezoid, pentagon, hexagon, etc. There may be some small deformations caused by tolerance, and there may be chamfer, arc edge, deformation, etc.

In an embodiment of the present disclosure, "about" refers to a value that is not strictly limited, a value within a range of process and measurement error is allowed.

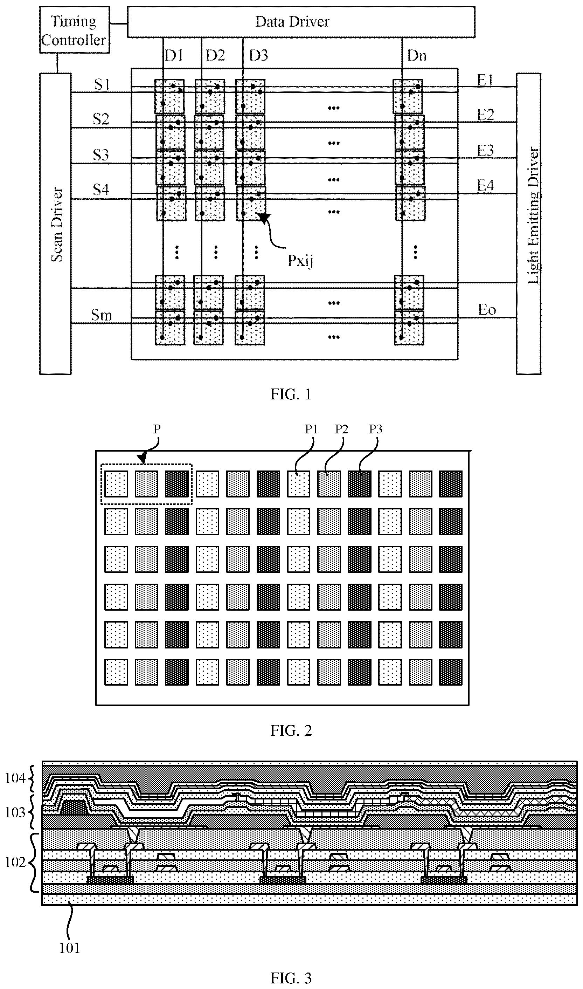

FIG. 1 is a schematic diagram of a structure of a display device. As shown in FIG. 1, the display device may include a timing controller, a data driver, a scan driver, a light emitting driver, and a pixel array. The timing controller is connected to the data driver, the scan driver, and the light emitting driver, respectively, the data driver is connected to a plurality of data signal lines (D1 to Dn) respectively, the scan driver is connected to a plurality of scan signal lines (S1 to Sm) respectively, and the light emitting driver is connected to a plurality of light emitting signal lines (E1 to Eo) respectively. The pixel array may include multiple sub-pixels Pxij, wherein i and j may be natural numbers. At least one sub-pixel Pxij may include a circuit unit and a light emitting device connected to the circuit unit, wherein the circuit unit may include a pixel drive circuit, and the pixel drive circuit is connected to a scan signal line, a data signal line, and a light emitting signal line, respectively. In an exemplary implementation, the timing controller may provide the data driver with a gray scale value and a control signal which are suitable for the specification of the data driver, provide the scan driver with a clock signal and a scan start signal and the like which are suitable for the specification of the scan driver, and provide the light emitting driver with a clock signal and an emission stop signal and the like which are suitable for the specification of the light emitting driver. The data driver may generate data voltages to be provided to the data signal lines D1, D2, D3, ..., and Dn using the grayscale value and the control signal that are received from the timing controller. For example, the data driver may sample the gray scale value using the clock signal and apply a data voltage corresponding to the gray scale value to the data signal lines D1 to Dn by taking a pixel row as a unit, wherein n may be a natural number. The scan driver may generate a scan signals to be provided to the scan signal lines S1, S2, S3, ..., and Sm by receiving the clock signal and the scan start signal from the timing controller. For example, the scan driver may sequentially provide a scan signal with an on-level pulse to the scan signal lines S1 to Sm. For example, the scan driver may be constructed in a form of a shift register and generate a scan signal in a manner of sequentially transmitting scan start signals provided in a form of an on-level pulse to a next-stage circuit under control of the clock signal, wherein m may be a natural number. The light emitting driver may receive a clock signal, an emission stop signal, etc., from the timing controller to generate an emission signal to be provided to the light emitting signal lines E1, E2, E3, ..., and Eo. For example, the light emitting driver may sequentially provide an emission signal with an off-level pulse to the light emitting signal lines E1 to Eo. For example, the light emitting driver may be constructed in a form of a shift register and generate an emission signal in a manner of sequentially transmitting an emission stop signal provided in a form of an off-level pulse to a next-stage circuit under control of the clock signal, wherein o may be a natural number.

FIG. 2 is a schematic diagram of a planar structure of a display substrate. In an exemplary implementation, the display substrate may include multiple pixel units P arranged in a matrix manner, at least one pixel unit P may include a first sub-pixel P1 emitting a first color light, a second sub-pixel P2 emitting a second color light, and a third sub-pixel P3 emitting a third color light. Each of the three sub-pixels may include a circuit unit and a light emitting unit. The circuit unit may include a pixel drive circuit. The pixel drive circuit is respectively connected to the scan signal line, the data signal line, and the light emitting signal line. The pixel drive circuit is configured to receive the data voltage transmitted by the data signal line and output a corresponding current to the light emitting unit under control of the scan signal line and the light emitting signal line. The light emitting unit is configured to emit a corresponding light in response to a current output by a pixel drive circuit connected thereto.

In an exemplary implementation, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light. In an exemplary implementation, a sub-pixel may be in a shape of a rectangle, a rhombus, a pentagon, or a hexagon. Three sub-pixels may be provided side by side horizontally, side by side vertically, or in a delta-shaped arrangement.

In another exemplary implementation, the pixel unit P may include four sub-pixels, which may be arranged side by side horizontally, side by side vertically, in a diamond shape or in a square, which is not limited in the present disclosure.

FIG. 3 is a schematic diagram of a sectional structure of a display substrate, and illustrates a structure of three sub-pixels of the display substrate. As shown in FIG. 3, on a plane perpendicular to the display substrate, the display substrate may include a drive circuit layer 102 arranged on a base substrate 101, a light emitting structure layer 103 arranged on a side of the drive circuit layer 102 away from the base substrate, and an encapsulation layer 104 arranged on a side of the light emitting structure layer 103 away from the base substrate. In some possible implementations, the display substrate may include another film layer, such as a post spacer, which is not limited in the present disclosure.

In an exemplary implementation, the base substrate 101 may be a flexible substrate, or may be a rigid substrate. The drive circuit layer 102 of each sub-pixel may (may be referred to as a circuit structure layer) include multiple circuit units which may include a pixel drive circuit formed by multiple transistors and a storage capacitor, and FIG. 3 is only illustrated by taking that the pixel drive circuit includes one drive transistor and one storage capacitor as an example. The light emitting structure layer 103 of each sub-pixel may include multiple light emitting units, and the emitting unit may include an anode, a pixel definition layer, an organic emitting layer, and a cathode, wherein the anode is connected to a drain electrode of a drive transistor through a via, the organic emitting layer is connected to the anode, the cathode is connected to the organic emitting layer, and the organic emitting layer emits light of a corresponding color under drive of the anode and the cathode. The encapsulation structure layer 104 may include a first encapsulation layer, a second encapsulation layer, and a third encapsulation layer that are stacked. The first encapsulation layer and the third encapsulation layer may be made of inorganic materials, and the second encapsulation layer may be made of an organic material. The second encapsulation layer is disposed between the first encapsulation layer and the third encapsulation layer, which may ensure that external water vapor cannot enter the light emitting structure layer 103.

In an exemplary implementation, the organic emitting layer may include an Emitting Layer (EML) and any one or more of a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation, hole injection layers, electron injection layers, hole transport layers, electron transport layers, hole block layers and electron block layers of all light emitting units may be connected together to form a common layer. Emitting layers of adjacent light emitting units may be overlapped slightly, or may be isolated.

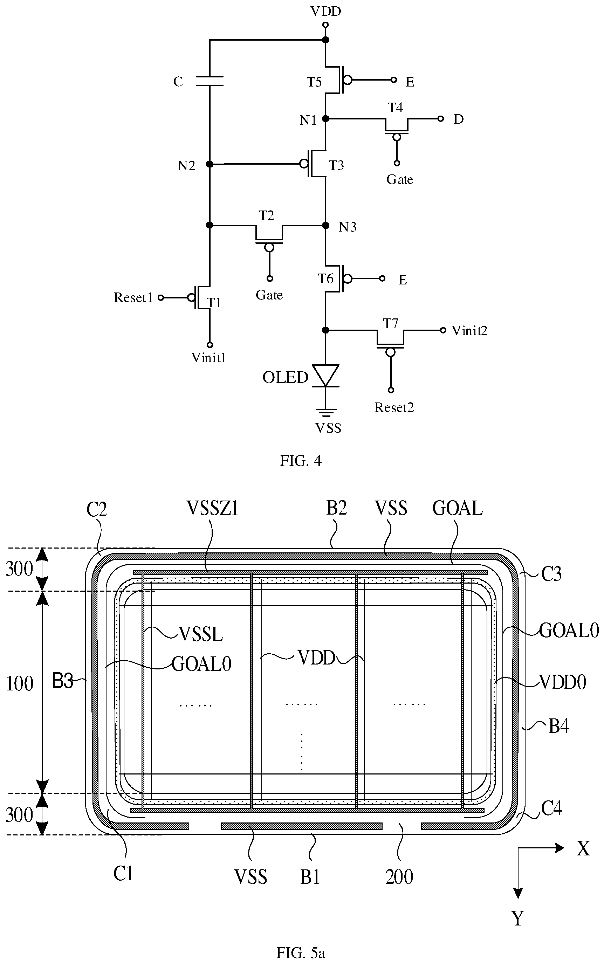

FIG. 4 is an equivalent circuit diagram of a pixel drive circuit. In an exemplary implementation, the pixel drive circuit may have a structure of 3T1C, 4T1C, 5T1C, 5T2C, 6T1C, 7T1C, or 8T1C. As shown in FIG. 4, the pixel drive circuit may include seven transistors (a first transistor T1 to a seventh transistor T7), one storage capacitor C, and the pixel drive circuit is respectively connected to nine signal lines (a data signal line D, a scan signal line Gate, a first reset control line Reset1, a second reset control line Reset2, a light emitting signal line E, a first initial signal line Vinit1, a second initial signal line Vinit2, a first power supply line VDD, and a second power supply line VSS).

In an exemplary implementation, the pixel drive circuit may include a first node N1, a second node N2, a third node N3, and a fourth node N4. Among them, the first node N1 is connected to a first electrode of the third transistor T3, a second electrode of the fourth transistor T4, and a second electrode of the fifth transistor T5 respectively. The second node N2 is connected to a second electrode of the first transistor T1, a first electrode of the second transistor T2, a control electrode of the third transistor T3, and a second terminal of the storage capacitor C respectively. The third node N3 is connected to a second electrode of the second transistor T2, a second electrode of the third transistor T3, and a first electrode of the sixth transistor T6 respectively. The fourth node N4 is connected to a second electrode of the sixth transistor T6, and a second electrode of the seventh transistor T7 respectively.

In an exemplary implementation, a first end of the storage capacitor C is connected to the first power supply line VDD, and the second end of the storage capacitor C is connected to the second node N2, i.e., the second end of the storage capacitor C is connected to the control electrode of the third transistor T3.

A control electrode of the first transistor T1 is electrically connected to the first reset control line Reset1, a first electrode of the first transistor T1 is electrically connected to the initial signal line Vinit1, and a second electrode of the first transistor is electrically connected to a second node N2. When a scan signal with an on-level is applied to the first reset control line Reset1, the first transistor T1 transmits an initialization voltage to the control electrode of the third transistor T3, so as to initialize a charge amount of the control electrode of the third transistor T3.

A control electrode of the second transistor T2 is connected to the scan signal terminal Gate, a first electrode of the second transistor T2 is connected to the second node N2, and a second electrode of the second transistor T2 is connected to a third node N3. When a scan signal with an on-level is applied to the scan signal line Gate, the second transistor T2 enables the control electrode of the third transistor T3 to be connected to the second electrode of the third transistor T3.

A control electrode of the third transistor T3 is connected to the second node N2, i.e., the control electrode of the third transistor T3 is connected to the second end of the storage capacitor C, a first electrode of the third transistor T3 is connected to the first node N1, and the second electrode of the third transistor T3 is connected to the third node N3. The third transistor T3 may be referred to as a drive transistor, and the third transistor T3 determines an amount of a drive current flowing between the first power supply line VDD and the second power supply line VSS according to a potential difference between the control electrode and the first electrode of the third transistor T3.

A control electrode of the fourth transistor T4 is connected to the scan signal line Gate, a first electrode of the fourth transistor T4 is connected to the data signal line D, and a second electrode of the fourth transistor T4 is connected to the first node N1. The fourth transistor T4 may be referred to as a switching transistor, a scan transistor, etc., and the fourth transistor T4 enables a data voltage of the data signal line D to be input into the pixel drive circuit when a scan signal with an on-level is applied to the scan signal line Gate.

A control electrode of the fifth transistor T5 is connected to the light emitting signal line E, a first electrode of the fifth transistor T5 is connected to the first power supply line VDD, and a second electrode of the fifth transistor T5 is connected to the first node N1. The control electrode of the sixth transistor T6 is connected to the light emitting signal line E, the first electrode of the sixth transistor T6 is connected to the third node N3, and the second electrode of the sixth transistor T6 is connected to the first electrode of the light emitting device EL. The fifth transistor T5 and the sixth transistor T6 may be referred to as light emitting transistors. When a light emitting signal with an on-level is applied to the light emitting signal line E, the fifth transistor T5 and the sixth transistor T6 enable the light emitting device EL to emit light by forming a drive current path between the first power supply line VDD and the second power supply line VSS.

A control electrode of the seventh transistor T7 is electrically connected to a second reset control line Reset2, a first electrode of the seventh transistor T7 is connected to a second initial signal line Vinit2, and a second electrode of the seventh transistor T7 is electrically connected to the first electrode of the light emitting device EL. When a scan signal with an on-level is applied to the second reset control line Reset2, the seventh transistor T7 transmits an initialization voltage to the first electrode of the light emitting device EL so as to initialize a charge amount accumulated in the first electrode of the light emitting device EL or release a charge amount accumulated in the first electrode of the light emitting device EL.

In an exemplary implementation, the light emitting device EL may be an OLED including a first electrode (anode), an organic light emitting layer, and a second electrode (cathode), which are stacked, or may be a QLED including a first electrode (anode), a quantum dot light emitting layer, and a second electrode (cathode), which are stacked.

In an exemplary implementation, a second electrode of the light emitting device EL is connected to the second power supply line VSS, a signal of the second power supply line VSS is a low level signal continuously provided, and a signal of the first power supply line VDD is a high level signal continuously provided.

In an exemplary implementation, the first transistor T1 to the seventh transistor T7 may be P-type transistors, or may be N-type transistors. Use of a same type of transistors in a pixel drive circuit may simplify a process flow, reduce a process difficulty of a display panel, and improve a product yield. In some possible implementations, the first transistor T1 to the seventh transistor T7 may include a P-type transistor and an N-type transistor.

In an exemplary implementation, for the first transistor T1 to the seventh transistor T7, low temperature poly silicon thin film transistors may be used, or oxide thin film transistors may be used, or both a low temperature poly silicon thin film transistor and an oxide thin film transistor may be used. An active layer of a low temperature poly silicon thin film transistor is made of Low Temperature Poly silicon (LTPS for short), and an active layer of an oxide thin film transistor is made of an oxide semiconductor (Oxide). A Low temperature poly silicon thin film transistor has advantages such as a high migration rate and fast charging, and an oxide thin film transistor has advantages such as a low leakage current. The low temperature poly silicon thin film transistor and the oxide thin film transistor are integrated on one display substrate to form a Low Temperature Polycrystalline Oxide (LTPO for short) display substrate, so that advantages of both the low temperature poly silicon thin film transistor and the oxide thin film transistor may be utilized, low-frequency drive may be achieved, power consumption may be decreased, and display quality may be improved.

In an exemplary implementation, taking a case in which the seven transistors in the pixel drive circuit in FIG. 4 are all P-type transistors OLED as an example, the operation process of the pixel drive circuit may include following stages.

In a first stage A1, referred to as a reset stage, a signal of the first reset control line Reset1 is a low level signal, and signals of the scan signal line Gate and the light emitting signal line E are high level signals. The signal of the first reset control line Reset1 is the low level signal, so that the first transistor T1 is turned on, and a signal of the initial signal line INIT is provided to the second node N2 to initialize the storage capacitor C to clear an original data voltage in the storage capacitor. The signals of the scan signal line Gate, the second reset control line Reset2 and the light emitting signal line E are high level signals, so that the second transistor T2, the fourth transistor T4, the fifth transistor T5, the sixth transistor T6 and the seventh transistor T7 are turned off, therefore the OLED does not emit light in this stage.

In a second stage A2, referred to as a data writing stage or a threshold compensation stage, signals of the scan signal line Gate, the second reset control line Reset2 are low level signals, signals of the first reset control line Reset1 and the light emitting signal line E are high level signals, and the data signal line D outputs a data voltage. In this stage, the second end of the storage capacitor C is at a low level, so the third transistor T3 is turned on. Signals of the scan signal line Gate, the second reset control line Reset2 are low level signals, so that the second transistor T2, the fourth transistor T4, and the seventh transistor T7 are turned on. The second transistor T2 and the fourth transistor T4 are turned on, so that the data voltage output by the data signal line D is provided to the second node N2 through the first node N1, the turned-on third transistor T3, the third node N3, and the turned-on second transistor T2, and the storage capacitor C is charged with a difference between the data voltage output by the data signal line D and a threshold voltage of the third transistor T3. A voltage at the second end (the second node N2) of the storage capacitor C is Vd-IVthl, wherein Vd is the data voltage output by the data signal line D, and Vth is the threshold voltage of the third transistor T3. The seventh transistor T7 is turned on, so that an initialization voltage of the initial signal line INIT is provided to a first electrode of the OLED to initialize (reset) the first electrode of the OLED and clear a pre-stored voltage therein, thereby completing initialization and ensuring that the OLED does not emit light. A signal of the first reset control line Reset1 is a high level signal, so that the first transistor T1 is turned off. A signal of the light emitting signal line E is a high level signal, so that the fifth transistor T5 and the sixth transistor T6 are turned off.

In a third stage A3, referred to as a light emitting stage, a signal of the light emitting signal line E is a low level signal, and signals of the scan signal line Gate, the second reset control line Reset2, and the first reset control line Reset1 are high level signals. The signal of the light emitting signal line E is the low level signal, so that the fifth transistor T5 and the sixth transistor T6 are turned on, and a power voltage output by the first power supply line VDD provides a drive voltage to the first electrode of the OLED through the turned-on fifth transistor T5, the third transistor T3, and the sixth transistor T6 to drive the OLED to emit light.

In a drive process of the pixel drive circuit, a drive current flowing through the third transistor T3 (drive transistor) is determined by a voltage difference between a gate electrode and the first electrode of the third transistor T3. Since the voltage of the second node N2 is Vd-|Vth|, the drive current of the third transistor T3 is as follows.

$$I = K*(Vgs-Vth)^2 = K*[(Vdd-Vd+|Vth|)-Vth]^2 = K*[(Vdd-Vd)]^2$$

Herein, I is a drive current flowing through the third transistor T3, i.e., a drive current for driving the OLED, K is a constant, Vgs is the voltage difference between the gate electrode and the first electrode of the third transistor T3, Vth is the threshold voltage of the third transistor T3, Vd is the data voltage output by the data signal line D, and Vdd is the power voltage output by the first power supply line VDD.

With the development of OLED display technology, sizes of display products also increase. Due to a relatively long signal wiring in a large-size display products, a voltage drop on the signal wiring is large, making signals provided to different areas in the display product by the signal wiring are inconsistent, resulting in a problem of poor display uniformity in the display product.

In an exemplary embodiment of the present disclosure, there is provided a display substrate, which may include a base substrate, and second power supply lines and at least one second power supply connection line disposed on a side of the base substrate, wherein the base substrate may include a display area and a bezel area, the bezel area being located around the display area on a plane parallel to the display substrate, and the second power supply lines are disposed in the bezel area and at least on opposite sides of the display area; the at least one second power supply connection line is located in the display area and extends to opposite sides of the display area, and is electrically connected to a second power supply line located on at least one side of the display area.

In the display substrate provided by the embodiment of the present disclosure, the at least one second power supply connection line is located in the display area and extends to opposite sides of the display area, and is electrically connected to the second power supply line located on at least one side of the display area, so that a voltage drop of the second power supply line can be reduced, and second power supply signals at different positions on the second power supply line can be as consistent as possible, thereby improving the display uniformity.

In an exemplary implementation, a solution provided by an embodiment of the present disclosure can be applied to a display panel product with a larger size, and can improve the display uniformity of a display panel with a large size. The solution provided by the embodiment of the present disclosure is not limited to the display panel with the large size, for example, can be applied to a display panel with a small size or a medium size.

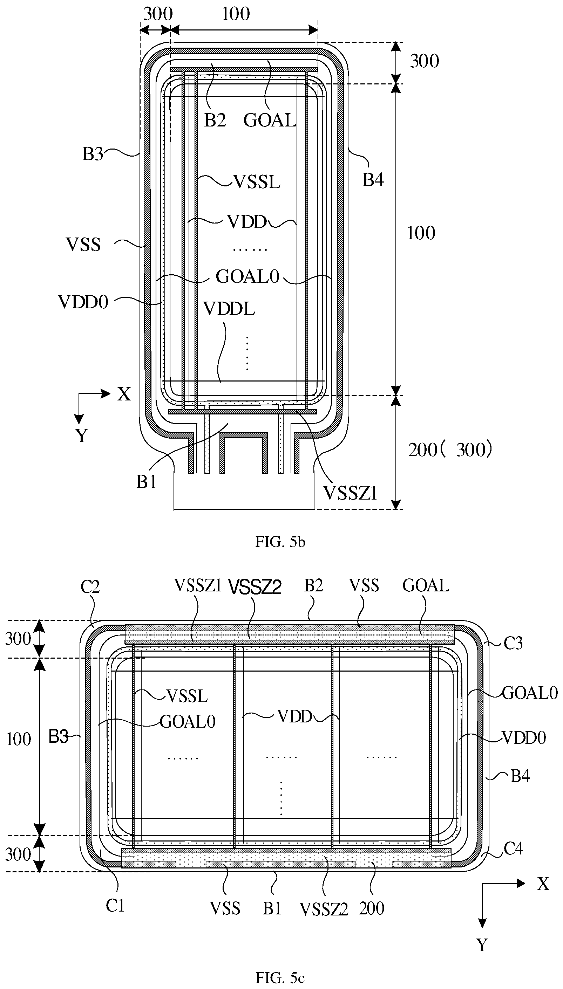

As shown in FIGS. 5a and 5b, a display substrate may include a base substrate, and second power supply lines VSS and at least one second power supply connection line VSSL disposed on a side of the base substrate. The base substrate may include a display area 100 and a bezel area 300, the bezel area 300 is located around the display area 100 on a plane parallel to the display substrate, and the second power supply lines VSS are disposed in the bezel area 300 and at least on opposite sides of the display area 100. The at least one second power supply connection line VSSL may be located in the display area 100 and extends to opposite sides of the display area 100, and is electrically connected to a second power supply line VSSL located on at least one side of the display area 100.

In an exemplary implementation, the second power supply connection lines VSSL may include a plurality of second power supply connection lines VSSL, and the plurality of second power supply connection lines VSSL may be arranged at intervals in a first direction X. In a structure of the display substrate shown in FIGS. 5a and 5b, since the second power supply lines VSS are disposed around a periphery of the display area 100, when a size of the display substrate is relatively large, lengths of the second power supply lines VSS is relatively long, so that voltage drops occur on the second power supply lines VSS, and signals of the second power supply lines VSS received by different regions in the display substrate may have certain differences, resulting in a decrease in display uniformity of the display substrate. In a solution provided in an embodiment of the present disclosure, the second power supply line VSS located on at least one side of the display area 100 is electrically connected through the second power supply connection lines VSSL, and the second power supply lines VSS and the second power supply connection lines VSSL form into a grid-like shape, so that the voltage drops on the second power supply lines VSS can be reduced, thereby improving the display uniformity of the display substrate.

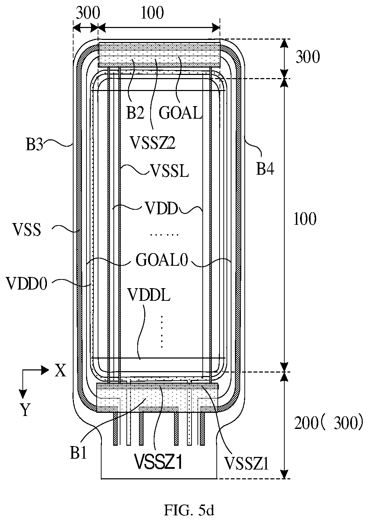

In an exemplary implementation, as shown in FIGS. 5a to 5d, the display substrate may further include second power supply adapt electrodes VSSZ2 and second power supply adapt lines VSSZ1 located in the bezel area 300, wherein on the plane parallel to the display substrate, the second power supply adapt lines VSSZ1 are located between the display area 100 and the second power supply lines VSS, two ends of a second power supply connection line VSSL are respectively connected to the second power supply adapt lines VSSZ1 located on opposite sides of the display area 100, and in a direction perpendicular to the plane on which the display substrate is located, the second power supply adapt electrodes VSSZ2 may be located on a side of the second power supply connection lines VSSL and the second power supply lines VSS away from the base substrate, the second power supply lines VSS and the second power supply adapt lines VSSZ1 may be electrically connected through the second power supply adapt electrodes VSSZ2. FIG. 5c is a schematic diagram after the second power supply adapt electrodes VSSZ2 are formed on a basis of FIG. 5a, and FIG. 5d is a schematic diagram after the second power supply adapt electrodes VSSZ2 are formed on a basis of FIG. 5b.

In an exemplary implementation, as shown in FIGS. 5c and 5d, orthographic projections of the second power supply adapt electrodes VSSZ2 on the base substrate is at least partially overlapped with orthographic projections of the second power supply adapt lines VSSZ1 and the second power supply lines VSS on the base substrate, and the second power supply adapt electrodes VSSZ2 are electrically connected to the second power supply lines VSS and the second power supply adapt lines VSSZ1 through vias, respectively.

In an exemplary implementation, as shown in FIGS. 5a to 5d, the bezel area 300 may include a first bezel region B1 and a second bezel region B2 located on two sides of the display area 100 in a second direction Y, and a third bezel region B3 and a fourth bezel region B4 located on two sides of the display area 100 in a first direction X. The second bezel region B2 is provided with at least one drive signal connection line GOAL, the third bezel region B3 and the fourth bezel region B4 are respectively provided with at least one type of drive signal line GOAL0, and drive signal lines GOALO of a same type located in the third bezel region B3 and the fourth bezel region B4 are electrically connected through one drive signal connection line GOAL. On a plane parallel to the display substrate, the drive signal connection line GOAL may be located between the second power supply lines VSS and a second power supply adapt line VSSZ1, the drive signal lines GOALO may be located between the second power supply lines VSS and the display area 100, the first direction X intersecting with the second direction Y.

In an exemplary implementation, by electrically connecting the drive signal lines GOALO of the same type located in the third bezel region 300 and the fourth bezel region 300 through one drive signal connection line GOAL, an embodiment of the present disclosure enable signals provided by the drive signal lines GOALO of the same type located in the third bezel region B3 and the fourth bezel region B4 to be kept as consistent as possible, so that the display uniformity of the display substrate can be improved. In an exemplary implementation, each drive signal connection line GOAL is electrically connected to one type of the drive signal lines GOAL0.

In an exemplary implementation, the drive signal lines GOALO may include clock signal lines, gate drive signal lines, initial signal power supply lines, and the like. For example, clock signal lines of a same type located in the third bezel B3 and the fourth bezel region B4 may be electrically connected through one drive signal connection line GOAL.

As shown in FIGS. 5a to 5d, the display area 100 may include at least one corner area, the bezel area 300 may include at least one corner area, and the at least one corner area of the display area 100 corresponds to the at least one corner area of the bezel area 300.

In an exemplary implementation, as shown in FIG. 5a, at least one corner area of the bezel area 300 may include: a first corner area C1 connecting the first bezel region B1 and the third bezel region B3, a second corner area C2 connecting the third bezel region B3 and the second bezel region B2, a third corner area C3 connecting the second bezel region B2 and the fourth bezel region B4, and a fourth corner area C4 connecting the fourth bezel region B4 and the first bezel region B1.

In an exemplary implementation, as shown in FIGS. 5a and 5b, the base substrate may further include a bonding region 200, and on a plane parallel to the display substrate, the bonding region 200 may be located on one side of the display area 100, the second power supply lines VSS are at least located in the bonding region 200 and on a side of the display area 100 away from the bonding region 200, and at least one second power supply connection line VSSL extends in a direction from the bonding region 200 to the display area 100. In an exemplary implementation, as shown in FIGS. 5a and 5b, the second power supply connection lines VSSL may extend in the second direction Y. In an embodiment of the present disclosure, the second power supply connection lines VSSL electrically connect the second power supply lines VSS located in the bonding region 200 and on the side of the display area 100 away from the bonding region 200, so that potentials of the second power supply lines VSS located in the bonding region 200 and on the side of the display area 100 away from the bonding region 200 can be kept as consistent as possible, thereby improving the display uniformity of the display substrate.

In an exemplary implementation, as shown in FIGS. 5a to 5d, the bonding region 200 may be located in the first bezel region B1, and the second power supply adapt electrodes VSSZ2 and the second power supply adapt lines VSSZ1 may be located in the first bezel region B1 and the second bezel region B2.

In an exemplary implementation, as shown in FIGS. 5a and 5b, the display substrate may further include a first power supply signal supply line VDDO, which may be disposed in the bezel area 300 and located around the display area 100 in directions parallel to the plane on which the display substrate is located, and in the first bezel region B1 or the second bezel region B2, the first power supply signal supply line VDDO may be located between the second power supply adapt lines VSSZ1 and the display area 100, and in the third bezel region B3 or the fourth bezel region B4, the first power supply signal supply line VDDO may be located between the drive signal lines GOALO and the display area 100.

In an exemplary implementation, the display substrate may further include a plurality of first power supply connection lines VDDL and a plurality of first power supply lines VDD located in the display area 100, wherein the display area 100 may further be provided with a plurality of sub-pixels arranged in an array, the plurality of first power supply connection lines VDDL may extend in the first direction X and be arranged at intervals in the second direction Y, and the plurality of first power supply lines VDD may extend in the second direction Y and be arranged at intervals in the first direction X.

both ends of the first power supply connection lines VDDL are electrically connected to the first power supply signal supply line VDDO located in the third bezel B3 and the fourth bezel B4, respectively, and middle parts of the first power supply connection lines VDDL are electrically connected to at least one row of sub-pixels; in the direction perpendicular to the plane on which the display substrate is located, the first power supply lines VDD may be located on a side of the first power supply connection lines VDDL and the first power supply signal supply line VDDO away from the base substrate, middle parts of the first power supply lines VDD are electrically connected to the plurality of first power supply connection lines VDDL, and both ends of the first power supply lines VDD are electrically connected to the first power supply signal supply line VDDO located in the first bezel region B1 and the second bezel region B2, respectively.

In an exemplary implementation, in the second direction Y, both sizes of the first power supply signal supply line VDDO and the second power supply lines VSS may be larger than sizes of the second power supply adapt lines VSSZ1. For example, in the second bezel region B2, the sizes of the first power supply signal supply line VDDO and the second power supply lines VSS may be larger than the sizes of the second power supply adapt lines VSSZ1, and since the second power supply connection lines VSSL are provided in the display area 100, widths (sizes in the second direction Y) of the second power supply adapt lines VSSZ1 may be appropriately reduced, thereby saving the bezel while reducing the voltage drops of the second power supply lines VSS.

In an exemplary implementation, the middle parts of the first power supply lines VDD can be electrically connected to a plurality of first power supply connection lines VDDL through vias, and both ends of the first power supply lines VDD located in the first bezel region B1 and the second bezel region B2 can be electrically connected to the first power supply signal supply line VDDO through vias. In an exemplary implementation, the drive signal connection lines GOAL and the first power supply lines VDD may be located in a second source drain metal layer, and the first power supply signal supply line VDDO and the first power supply connection lines VDDL may be located in a first source drain metal layer. In an exemplary implementation, the first power supply signal supply line VDDO and the plurality of first power supply connection lines VDDL may be formed into an integral structure.

In an exemplary implementation, the display substrate may further include an anode conductive layer and a cathode layer, wherein in the direction perpendicular to the plane on which the display substrate is located, the cathode layer may be located on a side of the anode conductive layer away from the base substrate; the second power supply adapt electrodes VSSZ2 may be located in the anode conductive layer, orthographic projections of the second power supply adapt electrodes VSSZ2 on the base substrate are at least partially overlapped with an orthographic projection of the cathode layer on the base substrate, and the second power supply adapt electrodes VSSZ2 may be electrically connected to the cathode layer. In an exemplary implementation, the second power supply adapt electrodes VSSZ2 and the cathode layer may be electrically connected through vias, or the second power supply adapt electrodes VSSZ2 and the cathode layer may be electrically connected through slots. In an exemplary implementation, the anode conductive layer may be located on a side of the second source drain metal layer away from the base substrate. In an exemplary implementation, the second power supply connection lines VSSL may be located in the second source drain metal layer, the second power supply lines VSS may be a double-layer structure located in the first source drain metal layer and the second source drain metal layer, and the second power supply lines VSS are disposed in the double-layer structure to reduce the voltage drops on the second power supply lines VSS, so that the second power supply signals supplied to the display substrate is as consistent as possible, thereby improving the display uniformity.

In an exemplary implementation, the bonding region 200 may be provided with a data drive circuit (or which may be referred to as a data drive IC) and a gate drive circuit (or which may be referred to as a gate drive IC), wherein in the first direction X, the gate drive circuit may be disposed on both sides of the data drive circuit; the first power supply signal supply line VDDO may be electrically connected to the data drive circuit in the bonding region 200, and a first power supply signal is provided to the first power supply signal supply line VDDO by the data drive circuit; the second power supply lines VSS may be electrically connected to a data drive circuit or a gate drive circuit in the bonding region 200, and the data drive circuit or the gate drive circuit may be electrically connected to provide a second power supply signal to the second power supply lines VSS; the third bezel region B3 and the fourth bezel region B4 may be provided with gate drive circuits (which may be referred to as Gate Drivers on Array, abbreviated as GOA circuits), the GOA circuits may be located between the second power supply lines VSS and the display area 100, input terminals of the GOA circuits may be electrically connected to a plurality of drive signal lines GOAL0, output terminals of the GOA circuit may be electrically connected to the sub-pixels located in the display area 100, and each GOA circuit may be disposed to provide a GOA signal (or which may be referred to as a scan signal) to one or more rows of sub-pixels in the display area 100.

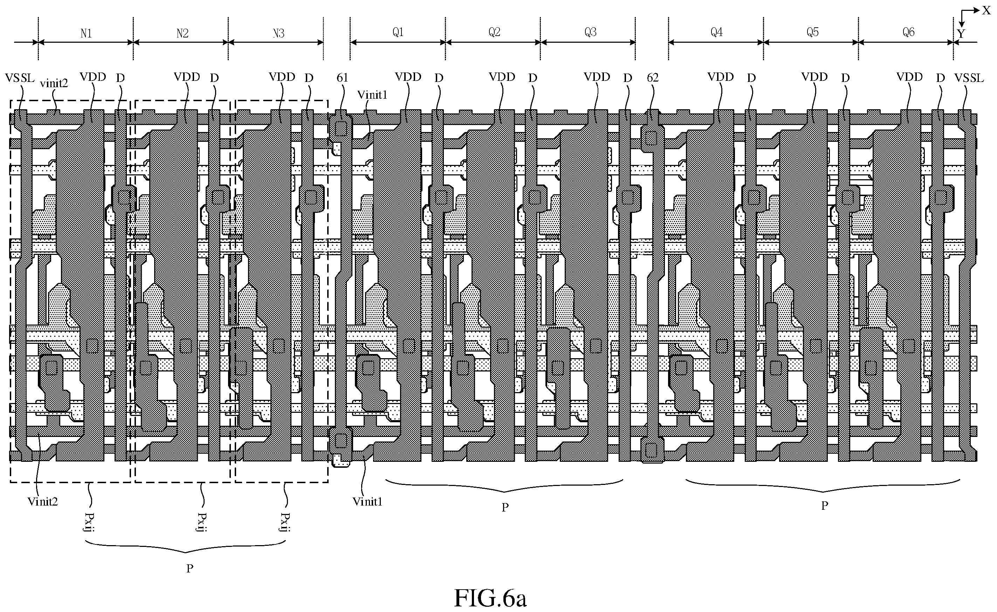

In an exemplary implementation, as shown in FIG. 6a, the quantity of the second power supply connection lines VSSL may be a plurality, the display area 100 may include a plurality of sub-pixels Pxij arranged in an array, the plurality of second power supply connection lines VSSL may be arranged in a row direction X and extend in a column direction Y, at least one second power supply connection line VSSL may be disposed between two adjacent columns of sub-pixels, and the row direction X may intersect with the column direction Y on a plane parallel to the display substrate. In the exemplary implementation, the row direction X may be the first direction X, and the column direction Y may be the second direction Y.

In an exemplary implementation, the display area 100 may further include a plurality of initial signal lines and a plurality of initial signal connection lines, wherein the plurality of initial signal lines may be configured to be electrically connected to a plurality of rows of sub-pixels, respectively, and the initial signal connection lines may be configured to be electrically connected to at least some of the initial signal lines; in a direction parallel to the plane on which the display substrate is located, the plurality of initial signal lines extend in the row direction X and are arranged at intervals in the column direction Y, and the plurality of initial signal connection lines extend in the column direction Y and are arranged at intervals in the row direction X, and in a direction perpendicular to the plane on which the display substrate is located, the plurality of initial signal connection lines and the plurality of initial signal lines may be located in different conductive layers. For example, the plurality of initial signal connection lines may be located on a side of the plurality of initial signal lines away from the base substrate.

In an exemplary implementation, as shown in FIG. 6a, the plurality of initial signal lines may include a plurality of first initial signal lines Vinit1 and a plurality of second initial signal lines Vinit2, and at least some of the sub-pixels may include a plurality of transistors, the plurality of transistors including at least first transistors and seventh transistors; the plurality of first initial signal lines Vinit1 are configured to be electrically connected to the first transistors in the plurality of rows of sub-pixels respectively, and the plurality of second initial signal lines Vinit2 are configured to be electrically connected to the seventh transistors in the plurality of rows of sub-pixels respectively;

the plurality of initial signal connection lines may include a plurality of first initial signal connection lines 61 and a plurality of second initial signal connection lines 62; the first initial signal connection lines 61 are configured to be electrically connected to the plurality of first initial signal lines Vinit1, and the second initial signal connection lines 62 are configured to be electrically connected to the plurality of second initial signal lines Vinit2.

In an embodiment of the present disclosure, the first initial signal connection lines 61 are electrically connected to the plurality of first initial signal lines Vinit1, so that the first initial signals received by the plurality of sub-pixels located in a same column have substantially the same potential, and the second initial signal connection lines 62 are electrically connected to the plurality of second initial signal lines Vinit2, so that the second initial signals received by the plurality of sub-pixels located in a same column have substantially the same potential, so that the display uniformity of the display substrate can be improved.

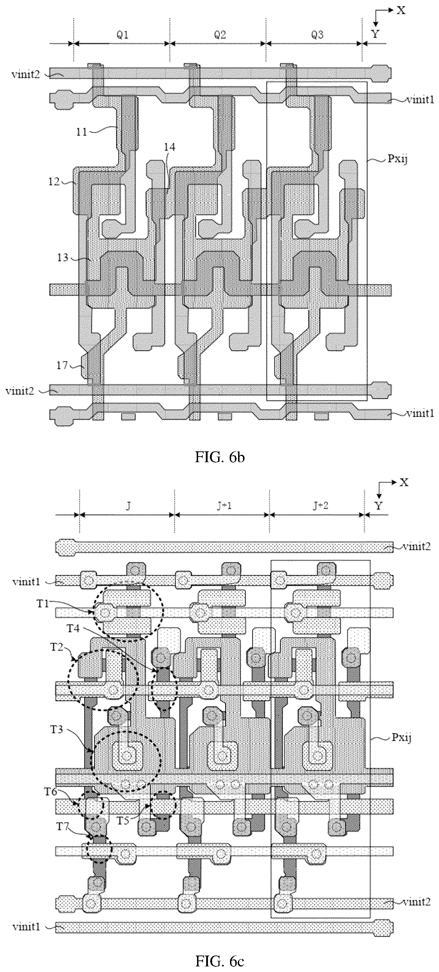

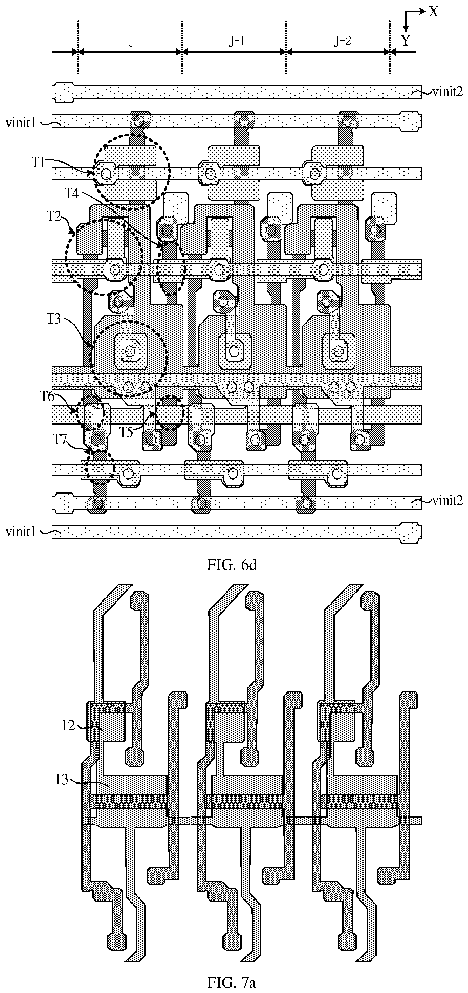

In an exemplary implementation, the display substrate may include a semiconductor layer, a second conductive layer, a third conductive layer, and a fourth conductive layer sequentially disposed on the base substrate in the direction perpendicular to the plane on which the display substrate is located, and the plurality of initial signal lines may be disposed on one of the semiconductor layer, the second conductive layer, and the third conductive layer. As shown in FIG. 6b, the plurality of initial signal lines may be disposed in the semiconductor layer; as shown in FIG. 6c, the plurality of initial signal lines may be disposed in the second conductive layer; and as shown in FIG. 6d, the plurality of initial signal lines may be disposed in the third conductive layer. In an exemplary implementation, the plurality of initial signal connection lines may be disposed in the fourth conductive layer. In the structure shown in FIG. 6b, the plurality of initial signal lines are disposed on the semiconductor layer, and the plurality of initial signal lines do not need to be electrically connected to active layers through vias, which reduces the quantity of vias, saves the space of the display substrate to a certain extent, and can increase the PPI (Pixels Per Inch, which can be referred to as a pixel density) of the display substrate. In the structures shown in FIGS. 6c and 6d, the plurality of initial signal lines need to be provided with vias to electrically connected to the active layers. Compared with the structure shown in FIG. 6b, the space for disposing the vias is added, so the PPI of the display substrate in FIGS. 6c or 6d is relatively lower than that of the display substrate in FIG. 6b.

In an exemplary implementation, as shown in FIG. 6a, a plurality of sub-pixels may form a plurality of pixel units P arranged in an array, at least some of the pixel units including at least three sub-pixels sequentially arranged in the row direction X, and a second power supply connection line VSSL, the first initial signal lines Vinit1, and the second initial signal lines Vinit2 are disposed between two adjacent columns of pixel units.

In an exemplary implementation, the second power supply connection lines VSSL, the first initial signal connection lines 61, and the second initial signal connection lines 62 may be arranged periodically in the row direction X.

In an exemplary implementation, in one period, a second power supply connection line VSSL, a first initial signal connection line 61, and a second initial signal line connection line 62 are arranged sequentially in the row direction X, R column pixel units are spaced between the second power supply connection line VSSL and the first initial signal connection line 61, R column pixel units are spaced between the first initial signal connection line 61 and the second initial signal connection line 62, and R column pixel units are spaced between the second initial signal connection line 62 and a second power supply connection line VSSL in an adjacent period, where R is an integer greater than or equal to 1.

In an exemplary implementation, two first initial signal connection lines 61, two second initial signal connection lines 62 and a second power supply connection line VSSL may be included in one period, and the two first initial signal connection lines 61 and the two second initial signal connection lines 62 may be located on both sides of the second power supply connection line VSSL in the row direction X, the first initial signal connection line 61 and the second initial signal connection line 62 are sequentially arranged on a same side of the second power supply connection line VSSL in the row direction X.

In a same period, R columns of pixel units are spaced between a first initial signal connection line 61 and an adjacent second initial signal connection line 62, and R columns of pixel units are spaced between a second power supply connection line VSSL and an adjacent first initial signal connection line 61 and an adjacent second initial signal connection line 62, where R is an integer greater than or equal to 1.

In an exemplary implementation, as shown in FIGS. 6b, 7a to 7e, the display substrate may further include a shield layer and a circuit structure layer disposed on the base substrate, and the shield layer may be located between the base substrate and the circuit structure layer in the direction perpendicular to the plane on which the display substrate is located.

In an exemplary implementation, as shown in FIGS. 6b, 7a to 7e, the display area 100 is provided with a plurality of sub-pixels Pxij, at least some of the sub-pixels including first transistors T1 to seventh transistors T7 in the circuit structure layer and at least one shield structure in the shield layer, and each shield structure being disposed to shield a channel region of at least one of a first transistor to a seventh transistor in a same sub-pixel. A transistor located in the circuit structure layer is shielded by the shield structure, so that the stability of the corresponding transistor can be improved. In the exemplary implementation, a PI layer (polyimide layer) is provided in the base substrate. During the operation of the display substrate, the PI layer can accumulate charges, thereby affecting the transistors disposed on the base substrate, causing the transistors to operate unstably, causing the display panel to have afterimages and bright spots. The transistors are shielded by the shield layer, so that the influence of the charges of the PI layer on the transistors can be reduced to a certain extent.

In an exemplary implementation, in a same sub-pixel, the shield layer may include one or more of a first shield structure 11 to a seventh shield structure 17, wherein an orthographic projection of the first shield structure 11 on the base substrate is at least partially overlapped with an orthographic projection of the first transistor on the base substrate; an orthographic projection of a second shield structure 12 on the base substrate is at least partially overlapped with an orthographic projection of a second transistor on the base substrate; an orthographic projection of the third shield structure 13 on the base substrate is at least partially overlapped with an orthographic projection of a third transistor on the base substrate; an orthographic projection of a fourth shield structure 14 on the base substrate is at least partially overlapped with an orthographic projection of a fourth transistor on the base substrate; an orthographic projection of a fifth shield structure 15 on the base substrate is at least partially overlapped with an orthographic projection of a fifth transistor on the base substrate; an orthographic projection of a sixth shield structure 16 on the base substrate is at least partially overlapped with an orthographic projection of a sixth transistor on the base substrate; an orthographic projection of the seventh shield structure 17 on the base substrate is at least partially overlapped with an orthographic projection of the seventh transistor on the base substrate. For example, an orthographic projection of a channel region of the first transistor on the base substrate is within a range of the orthographic projection of the first shield structure 11 on the base substrate; an orthographic projection of a channel region of the second transistor on the base substrate is within a range of the orthographic projection of the second shield structure 12 on the base substrate; an orthographic projection of a channel region of the third transistor on the base substrate is within a range of the orthographic projection of the third shield structure 13 on the base substrate; an orthographic projection of a channel region of the fourth transistor on the base substrate is within a range of the orthographic projection of the fourth shield structure 14 on the base substrate; an orthographic projection of a channel region of the fifth transistor on the base substrate is within a range of the orthographic projection of the fifth shield structure 15 on the base substrate; an orthographic projection of a channel region of the sixth transistor on the base substrate is within a range of the orthographic projection of the sixth shield structure 16 on the base substrate; an orthographic projection of a channel region of the seventh transistor on the base substrate is within a range of the orthographic projection of the seventh shield structure 17 on the base substrate.

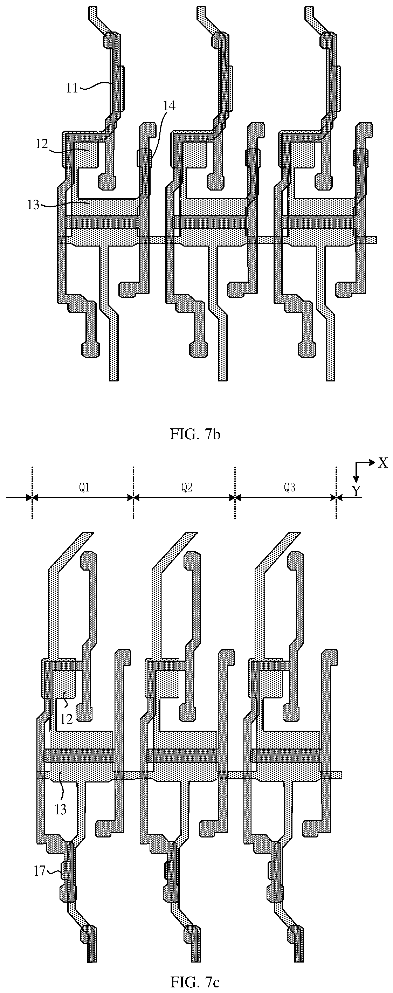

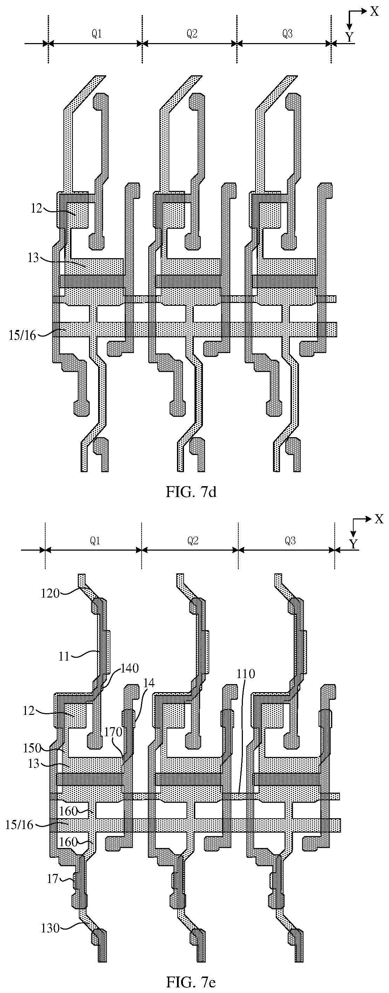

In an exemplary implementation, as shown in FIG. 6b, the shield layer may include first structures 11 to fourth shield structures 14 and seventh shield structures 17, so that channels of the first transistors T1 to the fourth transistors T4 and the seventh transistors T7 can be shielded, and the stability of the first transistors T1 to the fourth transistors T4 and the seventh transistors T7 can be improved; as shown in FIG. 7a, the shield structure layer may include second shield structures 12 to third shield structures 13, so that channels of the second transistors T2 and the third transistors T3 can be shielded, and the stability of the second transistors T2 to the third transistors T3 can be improved; as shown in FIG. 7b, the shield structure layer may include the first shield structure 11 to the fourth shield structure 14, so that the channels of the first transistors T1 to the fourth transistors T4 can be shielded, and the stability of the first shield structure 11 to the fourth shield structure 14 can be improved; as shown in FIG. 7c, the shield structure layer may include the second shield structure 12 to the third shield structure 13 and the seventh shield structure 17, so that channels of the second transistor T2, the third transistor T3 and the seventh transistor T7 can be shielded, and the stability of the second transistor T2 to the third transistor T3 and the seventh transistor T7 can be improved; as shown in FIG. 7d, the shield structure layer may include the second shield structure 12 to the third shield structure 13, the fifth shield structure 15 to the sixth shield structure 16, so that channels of the second transistor T2, the third transistor T3, the fifth transistor T5, and the sixth transistor T6 can be shielded, and the stability of the second transistor T2 to the third transistor T3, the fifth transistor T5 to the sixth transistor T6 can be improved, wherein the shield structure 15/16 of the fifth transistor T5 and the sixth transistor may be in a strip structure; as shown in FIG. 7e, the shield structure layer may include the first shield structure 11 to the seventh shield structure 17, so that the channels of the first to seventh transistors T1 to T7 can be shielded, so that the stability of the first to seventh transistors T1 to T7 can be improved.

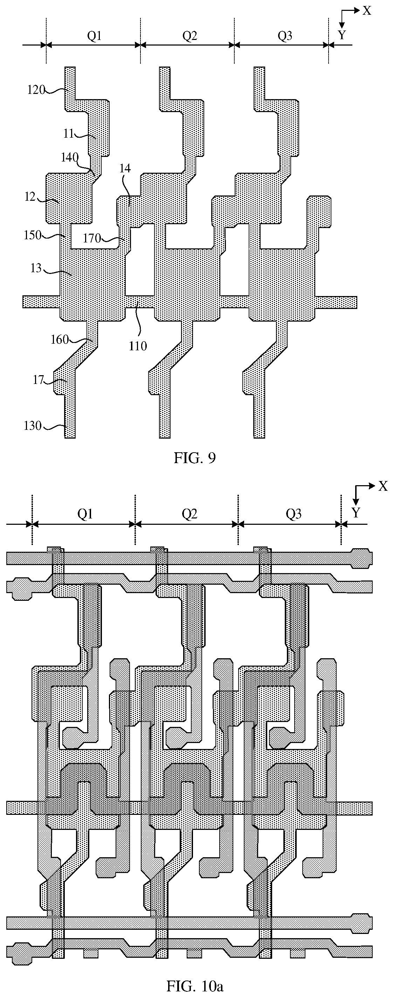

In an exemplary implementation, as shown in FIGS. 9 to 10a, a plurality of sub-pixels may form a plurality of sub-pixel rows, the shield layer may include second shield structures 12 and fourth shield structures 14, and in a same sub-pixel row, a second shield structure 12 located in one sub-pixel and a fourth shield structure 14 located in an adjacent sub-pixel may be formed into an integral structure.

In an exemplary implementation, as shown in FIGS. 9 to 10a, a plurality of sub-pixels may form a plurality of sub-pixel rows, the shield layer may include third shield structures 13 and, in a same sub-pixel row and in a row direction, a distance between two third shield structures 13 located in two adjacent sub-pixels is greater than a size of a channel region of a fourth transistor T4. That is, the distance between the two adjacent third shield structures 13 in the row direction X is greater than the size of the channel region of the fourth transistor T4 in the row direction X.

In an exemplary implementation, the shield structures in the shield layer in a same sub-pixel may be formed into an integral structure; the shield layer of a plurality of sub-pixels are connected to each other to be an integrated structure, which can make signals of the shield layers in the plurality of sub-pixels as consistent as possible, thereby improving the display uniformity.

In an exemplary implementation, as shown in FIG. 7e, the shield layer may further include first connection structures 110 to seventh connection structures 170, wherein, in the second direction Y, a sixth connection structure 160 may be located on both sides of a fifth shield structure 15 and a sixth shield structure 16, a first shield structure 11 at one end being connected to the shield layer of an adjacent row through a second connection structure 120, and at the other end being connected to a second shield structure 12 through a fourth connection structure 140; a side of the second shield structure 12 away from the first shield structure 11 is connected to a third shield structure 13 through a fifth connection structure 150; the third shield structure 13 is connected to the fifth shield structure 15 and the sixth shield structure 16 through the sixth connection structure 160; a fourth shield structure 14 is connected to the third shield structure 13 through a seventh connection structure 170; the seventh shield structure 17 at one end is connected to the fifth shield structure 15 and the sixth shield structure 16 through the sixth connection structure 160, and at the other end is connected to the shield layer of an adjacent row through a third connection structure 130; in the first direction X, third shield structures 13 of two adjacent shield layers may be connected through the first connection structures 110.

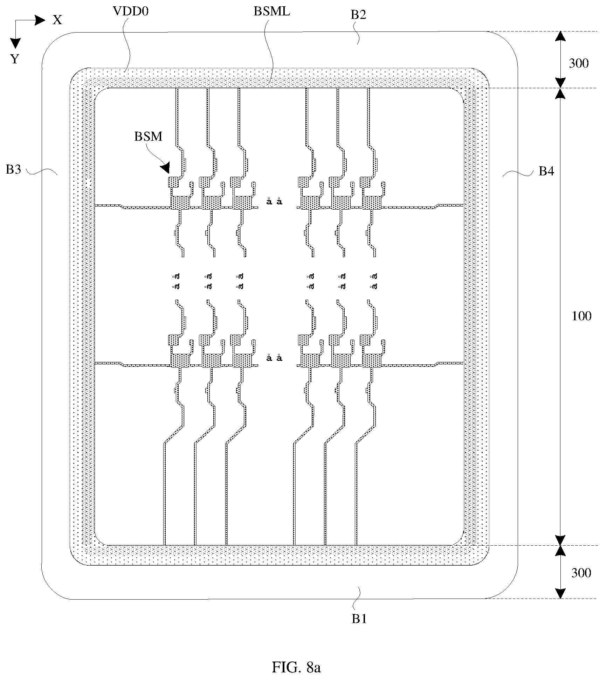

In an exemplary implementation, as shown in FIG. 8a, the display substrate may further include a first power supply signal supply line VDDO. The first power supply signal supply line may be disposed in the bezel area 300 and located around the display area 100, and in the direction perpendicular to the plane on which the display substrate is located, the first power supply signal supply line VDDO is located on a side of a shield layer BSM away from the base substrate, and shield layers BSM of a plurality of sub-pixels located on a side of the display area 100 close to the bezel area 300 are electrically connected to the first power supply signal supply line VDDO through vias. The first power supply signal is provided to the shield layers BSM through the first power supply signal supply line VDDO, so that charges of the PI layer in the base substrate is prevented from affecting the transistors, and the stability of the shielded transistor can be improved.

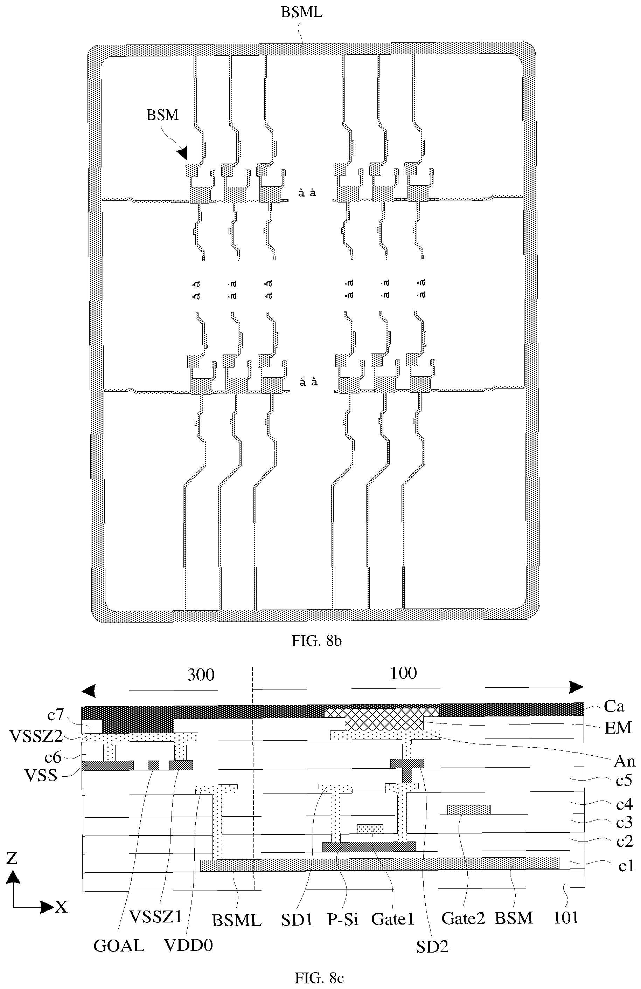

In an exemplary implementation, as shown in FIGS. 8a and 8b, FIG. 8b is a schematic diagram of a structure of a shield layer in FIG. 8a, the display substrate may further include shield adapt lines BSML located at least on both sides of a group of opposite sides of the display area 100, and on a plane parallel to the display substrate, the shield adapt lines BSML may be located between the second power supply lines VSS and the display area 100, shield layers of a plurality of sub-pixels located on the side of the display area 100 close to the bezel area 300 are connected to the shield adapt lines BSML, the first power supply signal supply line VDDO may be electrically connected to the shield adapt lines BSML through vias, and an orthographic projection of the first power supply signal supply line VDDO on the base substrate is at least partially overlapped with orthographic projections of the shield adapt lines BSML on the base substrate. In the exemplary implementation, the shield adapt lines BSML may be disposed in the first bezel B1 to the fourth bezel B4, or in the first bezel B1 and the second bezel B2, or in the third bezel B1 and the fourth bezel B4, which is not limited by the embodiment of the present disclosure. For example, the shield adapt lines BSML may be disposed in the first bezel B1 and the third bezel, or the shield adapt lines BSML may be disposed in the second bezel B2 and the third bezel B3.

As shown in FIG. 8c, FIG. 8c is a schematic diagram of a sectional structure of a display substrate at a abut position between the bezel area 300 and the display area 100, for example, may be a schematic diagram of a sectional structure at a abut position between the first bezel region B1 and the display area 100. In the structure shown in FIG. 8c, 101 is a base substrate, BSM is a shield layer, P-Si may be an active layer, Gate1 is a first conductive layer (which may be referred to as a first gate metal layer), Gate1 is a second conductive layer (which may be referred to as a second gate metal layer), SD1 is a third conductive layer (which may be referred to as a first source drain metal layer), SD2 is a fourth conductive layer (which may be referred to as a second source drain metal layer), An is an anode conductive layer, EM is an organic light emitting layer, Ca is a cathode layer, c1 is a first insulation layer, c2 is a second insulation layer, c3 is a third insulation layer, c4 is a fourth insulation layer, c5 is a fifth insulation layer (which may be referred to as a PVX layer) and a first planarization layer, c6 is a second planarization layer, c7 is a pixel defining layer. Elements corresponding to other designations in FIG. 8c can be referred to above and will not be repeated here.

In an exemplary implementation, the organic light emitting layer EM may employ a Tandem OLED device. A structure of the Tandem OLED device, that is, a sub-pixel includes multiple layers of light emitting layers, and a current required to achieve a same brightness is smaller than that of a single light emitting layer OLED device, and the smaller current can effectively reduce a power consumption of the Tandem OLED device and prolong a service life of the Tandem OLED device.

Exemplary description is made below through a preparation process of a display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a material on a base substrate (or substrate) using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are arranged in a same layer" in the present disclosure means that A and B are formed simultaneously through a same patterning process, and a "thickness" of a film layer is a dimension of the film layer in a direction perpendicular to a display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B.

In an exemplary implementation, taking three sub-pixels (1 sub-pixel row, 3 sub-pixel columns) in a display area (AA) as an example, a manufacturing process of a display substrate may include following operations.

(101) A substrate is prepared on a glass carrier plate. In an exemplary implementation, the base substrate may be a flexible substrate, or a rigid substrate. The rigid substrate may include, but is not limited to, one or more of glass and quartz. The flexible substrate may be, but is not limited to, one or more of polyethylene terephthalate, polyether ether ketone, polystyrene, polycarbonate, polyarylate, polyarylester, polyimide, polyvinyl chloride, polyethylene, and textile fiber. In an exemplary implementation, the flexible substrate may include a first flexible material layer, a first inorganic material layer, an adhesive layer, a second flexible material layer, and a second inorganic material layer which are stacked. Materials of the first flexible material layer and the second flexible material layer may be Polyimide (PI), Polyethylene Terephthalate (PET), or a polymer soft thin film subjected to surface treatment, etc. Materials of the first inorganic material layer and the second inorganic material layer may be Silicon Nitride (SiNx), Silicon Oxide (SiOx), or the like, so as to improve a water-oxygen resistance capability of the base substrate. The first inorganic material layer and the second inorganic material layer are also referred to as barrier layers. In an exemplary implementation, taking a stacked structure PI1/Barrier1/a-si/PI2/Barrier2 as an example, its manufacturing process may include: firstly coating a layer of polyimide on a glass carrier board, and curing it into a film to form a first flexible material (PI1) layer; then depositing a layer of barrier thin film on the first flexible layer to form a first barrier (Barrier1) layer overlying the first flexible material layer; then depositing a layer of amorphous silicon thin film on the first barrier layer to form an amorphous silicon (a-si) layer overlying the first barrier layer; then coating a layer of polyimide on the amorphous silicon layer, and curing it into a film to form a second flexible material (PI2) layer; and then depositing a barrier thin film on the second flexible layer to form a second barrier (Barrier2) layer overlying the second flexible layer, thus completing the manufacturing of the base substrate 101.

(102) A pattern of a shield layer is formed. In an exemplary implementation, forming the pattern of the shield layer may include: depositing a conductive thin film of the shield layer on the base substrate, patterning the conductive thin film of the shield layer through a patterning process, to form the pattern of the shield layer on the base substrate, as shown in FIG. 9, which is a planar structure view of patterns of the shield layers in three sub-pixels.

In an exemplary implementation, a pattern of a shield layer of each sub-pixel may include a first connection structure 110, a second connection structure 120, a third connection structure 130, a fourth connection structure 140, a fifth connection structure 150, a sixth connection structure 160, a seventh connection structure 170, a first shield structure, a second shield structure 12, a third shield structure 13, a fourth shield structure 14, and a seventh shield structure 17.

In an exemplary implementation, shapes of a first shield structure 11 to a fourth shield structure 14 and the seventh shield structures 17 may be rectangular, and corners of the rectangular shapes may be chamfered. In the second direction Y, the first shield structure 11 and the seventh shield structure 17 may be located on both sides of the third shield structure 13, the first shield structure 11 may be located on a side of the second shield structure 12 away from the third shield structure 13, and the seventh shield structure 17 may be located on a side of the third shield structure 13 in the second direction Y. In an exemplary implementation, in the second direction Y, the first shield structure 11 at one end is connected to the second connection structure 120, and the other end is connected to the fourth connection structure 140; the second shield structure 12 at one end is connected to the fourth connection structure 140, and at the other end is connected to the fifth connection structure 150; the third shield structure 13 at one end is connected to the fifth connection structure 150, and at the other end is connected to the sixth connection structure 160; the fourth shield structure 14 is connected to the third shield structure 13 through the seventh connection structure 170; the seventh shield structure 17 at one end is connected to the sixth connection structure 160, and at the other end is connected to the third connection structure 130. In an exemplary implementation, in the first direction X, the fourth shield structure 140 may be connected to a second shield structure 12 of an adjacent column.

In an exemplary implementation, the first connection structure 110 may be in a strip shape extending in the first direction X, and the first connection structure 110 is disposed on a side of the third shield structure 13 in the first direction X and is connected to the third shield structure 13. The second connection structure 120 may be in the shape of a polyline extending in the second direction Y, and the second connection structure 120 is disposed on a side of the first shield structure 11 in an opposite direction of the second direction Y, and is connected to the first shield structure 11. The third connection structure 130 may be in a strip shape extending in the second direction Y, and the third connection structure 130 is disposed on a side of the seventh shield structure 17 in the second direction Y and is connected to the seventh shield structure 17. The fourth connection structure 140 may be in a shape of a polyline extending in the second direction Y, and in the second direction Y, the fourth connection structure 140 at one end is connected to the first shield structure 11 and at the other end is connected to the second shield structure 12. The fifth connection structure 150 may be in a strip shape extending in the second direction Y and in the second direction Y, the fifth connection structure 150 at one end is connected to the third shield structure 13 and at the other end is connected to the second shield structure 12. The sixth connection structure 160 may be in a shape of a polyline extending in the second direction Y, and in the second direction Y, the sixth connection structure 160 at one end is connected to the third shield structure 13 and at the other end is connected to the seventh shield structure 17. The seventh connection structure 170 may be in a shape of a polyline extending in the second direction Y, and in the second direction Y, the seventh connection structure 170 at one end is connected to the third shield structure 13 and at the other end is connected to the fourth shield structure 14.

In an exemplary implementation, the first shield structure 110 of each sub-pixel is connected to the third shield structure 13 of an adjacent sub-pixel in the first direction X, such that the shield layers in a sub-pixel row are connected as a whole to form an interconnected integral structure.

In an exemplary implementation, the second shield structure 120 of each sub-pixel is connected to the third shield structure 130 of an adjacent sub-pixel in the second direction Y, such that the shield layers in a sub-pixel column are connected as a whole to form an interconnected integral structure.

In an exemplary implementation, the shield layers in a sub-pixel row and a sub-pixel column are connected as a whole, which may ensure that the shield layers in the display substrate have a same potential, and this is beneficial to improving uniformity of a panel, avoiding display defect of the display substrate, and ensuring a display effect of the display substrate.

In an exemplary implementation, shapes of the shield layers in a plurality of sub-pixel rows may be the same, and shapes of shield layers in a plurality of sub-pixel columns may be the same.

In an exemplary implementation, the shield layers may further include an shield adapt lines BSML as shown in FIGS. 8a to 8c, and the shield adapt lines BSML may be disposed in the bezel area 300 around the display area 100.

In an exemplary implementation, the patterns of the shield layers may be formed after manufacturing the second flexible material (PI2) layer, that is, the patterns of the shield layers may be disposed and manufactured on the second flexible material (PI2) layer, and after the manufacturing of the patterns of the shield layers is completed, a second barrier (Barrier2) layer is manufactured; alternatively, the patterns of the shield layers may be formed after the first flexible material (PI1) layer is manufactured, that is, the patterns of the shield layers may be manufactured on the first flexible material (PI1) layer, and the second flexible material (PI2) layer may be prepared after the patterns of the shield layers are manufactured, which is not limited by the embodiment of the present disclosure.

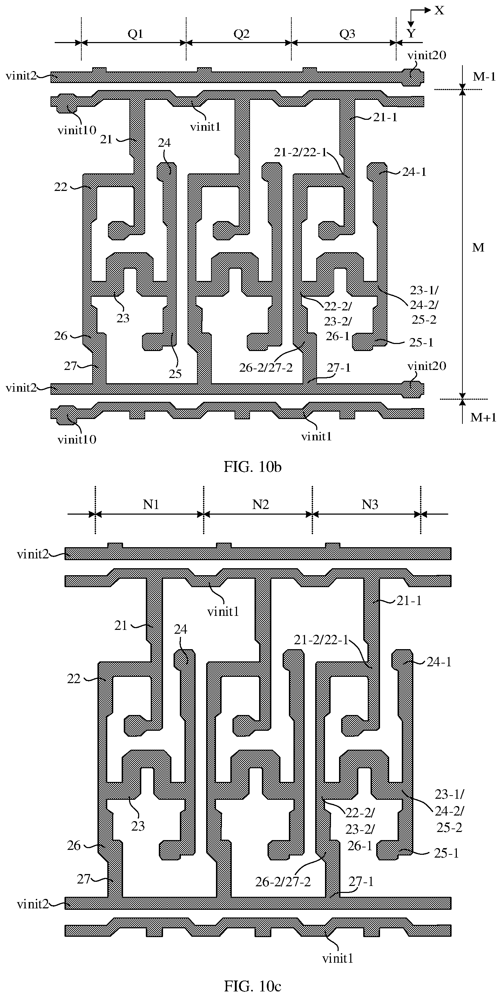

(103) A pattern of a semiconductor layer is formed. In an exemplary implementation, forming the pattern of the semiconductor layer may include: sequentially depositing a first insulation thin film and a first semiconductor thin film on the base substrate on which the aforementioned patterns are formed, patterning the first semiconductor thin film through a patterning process, to form a first insulation layer overlying the pattern of the shield layer, and the pattern of the semiconductor layer disposed on the first insulation layer, as shown in FIGS. 10a to 10c, FIG. 10a being a schematic diagram of a planar structure of three columns of sub-pixels (i.e., three sub-pixels) in a Q1-th column to a Q3-th column and in a row of sub-pixels, and FIG. 10b being a schematic diagram of a planar structure of the semiconductor layer in FIG. 10a; FIG. 10c shows schematic diagram of a structure of the semiconductor layer of three columns of sub-pixels from an N1-th column to an N3-th column in a row of sub-pixels.

In an exemplary implementation, a pattern of a semiconductor layer of each sub-pixel may include an active layer 21 of a first transistor T1 to an active layer 27 of a seventh transistor T7, a first initial signal line Vinit1, and a second initial signal line Vinit2, and the active layer 21 of the first transistor T1 to the active layer 27 of the seventh transistor T7 and the first initial signal line Vinit1 and the second initial signal line Vinit2 may be an interconnected integral structure.

In an exemplary implementation, in the first direction X, an active layer 24 of a fourth transistor T4 and an active layer 25 of a fifth transistor T5 are located on a same side of an active layer 23 of a third transistor T3, and an active layer 22 of a second transistor T2, an active layer 26 of a sixth transistor T6, and the active layer 27 of the seventh transistor T7 are located on the other side of the active layer 23 of the third transistor T3; in the second direction Y, the active layer 24 of the fourth transistor T4 and the active layer 25 of the fifth transistor T5 are located on both sides of the active layer 23 of the third transistor T3, and the active layer 25 of the fifth transistor T5, the active layer 26 of the sixth transistor T6, and the active layer 27 of the seventh transistor T7 are located on a same side of the active layer 23 of the third transistor T3, the active layer 27 of the seventh transistor T7 is located on a side of the active layer 26 of the sixth transistor T6 away from the active layer 23 of the third transistor T3, the active layer 24 of the fourth transistor T4, the active layer 22 of the second transistor T2, and the active layer 21 of the first transistor T1 are located on a same side the third transistor T3, and the active layer 21 of the first transistor T1 is located on a side of the active layer 22 of the second transistor T2 away from the active layer 23 of the third transistor T3. The first initial signal line Vinit1 is located on a side of the active layer of the first transistor T1 away from the active layer 21 of the second transistor T2, and is connected to an active layer 21 of a first transistor T1 in one row of sub-pixels; the second initial signal line Vinit2 is located on a side of the active layer 27 of the seventh transistor T7 away from the active layer 26 of the sixth transistor T6, and is connected to an active layer 27 of a seventh transistor T7 in one row of sub-pixels.

In the exemplary embodiment, taking a sub-pixel in an M-th row and in a Q2-th column as an example, in the first direction X, an active layer 24 of a fourth transistor T4 and an active layer 25 of a fifth transistor T5 are located on a side of an active layer 23 of a third transistor T3 away from sub-pixels in the Q1-th column, an active layer 22 of a second transistor T2, an active layer 26 of a sixth transistor T6, and an active layer 27 of a seventh transistor T7 are located on a side of the active layer 23 of the third transistor T3 away from sub-pixels in the Q3-th column; in the second direction Y, an active layer 21 of a first transistor T1, the active layer 22 of the second transistor T2, and the active layer 24 of the fourth transistor T4 are located on a side of the active layer 23 of the third transistor T3 away from sub-pixels in an (M+1)-th row, the active layer 25 of the fifth transistor T5, the active layer 26 of the sixth transistor T6, and the active layer 27 of the seventh transistor T7 are located on a side of the active layer 23 of the third transistor T3 away from sub-pixels in the (M-1)-th row, the active layer 27 of the seventh transistor T7 is located on a side of the active layer 26 of the sixth transistor T6 away from the active layer 23 of the third transistor T3, and the active layer 21 of the first transistor T1 is located on a side of the active layer 22 of the second transistor T2 away from the active layer 23 of the third transistor T3. The first initial signal line Vinit1 is located on a side of the active layer 21 of the first transistor T1 away from the active layer 21 of the second transistor T2 (on a side of the active layer 21 of the first transistor T1 close to the sub-pixels in the (M-1)-th row), and the second initial signal line Vinit2 is located on a side of the active layer 27 of the seventh transistor T7 away from the active layer 26 of the sixth transistor T6 (on a side of the active layer 27 of the seventh transistor T7 close to the sub-pixels in the (M+1)-th row).

In an exemplary implementation, the active layer 23 of the third transistor T3 may be in a shape of "Ω" or Chinese character "∏", the active layer 24 of the fourth transistor T4, the active layer 26 of the sixth transistor T6, and the active layer 27 of the seventh transistor T7 may be in a shape of "I", and the active layer 21 of the first transistor T1, the active layer 21 of the second transistor T2, and the active layer 25 of the fifth transistor T5 may be in a shape of "L".

In an exemplary implementation, an active layer of each transistor may include a first region, a second region, and a channel region located between the first region and the second region. In an exemplary implementation, a first region 21-1 of the active layer 21 of the first transistor T1 is connected to the first initial signal line Vinit1; a second region 21-2 of the active layer 21 of the first transistor T1 may be served as a first region 22-1 of the second transistor T2; a first region 23-1 of the active layer 23 of the third transistor T3 may be served as a second region 24-2 of the active layer 24 of the fourth transistor T4, a second region 25-2 of the active layer 25 of the fifth transistor T5; a second region 23-2 of the active layer 23 of the third transistor T3 may be served as a first region 26-1 of the active layer 26 of the sixth transistor T6, a second region 22-2 of the active layer 22 of the second transistor T2; a second region 26-2 of the active layer 26 of the sixth transistor T6 may be served as a second region 27-2 of the active layer 27 of the seventh transistor T7; a first region 27-1 of the active layer 27 of the seventh transistor T7 may be connected to the second initial signal line Vinit2; and a first region 24-1 of the active layer 24 of the fourth transistor T4 and a first region 25-1 of the active layer 25 of the fifth transistor T5 may be separately disposed.

In an exemplary implementation, an orthographic projection of the active layer 21 of the first transistor T1 on the base substrate is at least partially overlapped with an orthographic projection of a first shield structure 11 on the base substrate; an orthographic projection of the active layer 22 of the second transistor T2 on the base substrate is at least partially overlapped with an orthographic projection of a second shield structure 12 on the base substrate; an orthographic projection of the active layer 23 of the third transistor T3 on the base substrate is at least partially overlapped with an orthographic projection of a third shield structure 13 on the base substrate; an orthographic projection of the active layer 24 of the fourth transistor T4 on the base substrate is at least partially overlapped with an orthographic projection of a fourth shield structure 14 on the base substrate; and an orthographic projection of the active layer 27 of the seventh transistor T7 on the base substrate is at least partially overlapped with an orthographic projection of a seventh shield structure 17 on the base substrate. In an exemplary implementation, an orthographic projection of a channel region of the active layer 21 of the first transistor T1 on the base substrate is within a range of the orthographic projection of the first shield structure 11 on the base substrate; an orthographic projection of a channel region of the active layer 22 of the second transistor T2 on the base substrate is within a range of the orthographic projection of the second shield structure 12 on the base substrate; an orthographic projection of a channel region of the active layer 23 of the third transistor T3 on the base substrate is within a range of the orthographic projection range of the shield block 14 on the base substrate; an orthographic projection of a channel region of the active layer 24 of the fourth transistor T4 on the base substrate is within a range of the orthographic projection of the fourth shield structure 14 on the base substrate; and an orthographic projection of a channel region of the active layer 27 of the seventh transistor T7 on the base substrate is within a range of the orthographic projection of the seventh shield structure 17 on the base substrate, so that the stability of the first transistor T1, the second transistor T2, and the seventh transistor T7 can be improved.

In an exemplary implementation, a first initial signal line Vinit1 may be in a shape of a polyline extending in the first direction X. A plurality of first adapt electrodes Vinit10 are provided on the first initial signal line Vinit1. The first adapt electrodes Vinit10 are disposed to electrically connect the first initial signal line Vinit1 with a first initial signal connection line formed subsequently. A plurality of first initial signal lines Vinit1 are electrically connected to each other through the first initial signal connection line. The first initial signal line Vinit1 is configured to be connected to first regions 21-1 of active layers 21 of a plurality of first transistors T1 in one row of sub-pixels. First regions 21-1 of active layers 21 of a plurality of first transistors T1 in a same row of sub-pixels is connected to the first initial signal line Vinit1, and a plurality of first initial signal lines Vinit1 are electrically connected to each other through the first initial signal connection line formed subsequently, so that first electrodes of first transistors T1 of adjacent sub-pixels can be guaranteed to have the same potential, which is beneficial to improving the display uniformity of the panel, avoiding poor display of the display substrate, and ensuring the display effect of the display substrate.

In an exemplary implementation, a second initial signal line Vinit2 may be in a shape of a polyline extending in the first direction X. A plurality of second adapt electrodes Vinit20 are provided on the second initial signal line Vinit2, and the second adapt electrodes Vinit20 are disposed to electrically connect the second initial signal line Vinit2 with a second initial signal connection line formed subsequently. A plurality of second initial signal lines Vinit2 are electrically connected to each other through the second initial signal connection line. The second initial signal line Vinit2 is configured to be connected to first regions 27-1 of active layers 27 of a plurality of seventh transistors T7 in one row of the sub-pixels. First regions 27-1 of active layers 27 of a plurality of seventh transistors T7 in a same row of sub-pixels are connected to a second initial signal line Vinit2, and a plurality of rows of second initial signal lines Vinit2 are electrically connected to each other through the second initial signal connection line formed subsequently, so that first electrodes of seventh transistors T7 of adjacent sub-pixels can be guaranteed to have the same potential, which is beneficial to improving the display uniformity of the panel, avoiding poor display of the display substrate, and ensuring the display effect of the display substrate.

In an exemplary implementation, the first adapt electrodes Vinit 10 and the second adapt electrodes Vinit 20 may be alternately arranged in the first direction X. The first adapt electrodes Vinit 10 and the second adapt electrodes Vinit 20 may be arranged between two adjacent columns of sub-pixels. In a same row of sub-pixels, the first adapt electrodes Vinit 10 and the second adapt electrodes Vinit 20 may not be provided between all adjacent two sub-pixels. For example, in a same row of sub-pixels, adjacent first adapt electrode Vinit 10 and second adapt electrode Vinit 20 may be spaced by one or more sub-pixels. For example, the adjacent first adapt electrode Vinit 10 and second adapt electrode Vinit 20 may be spaced by three sub-pixels, which is not limited by the present disclosure. In an exemplary implementation, adjacent first adapt electrode Vinit 10 and second adapt electrode Vinit 20 may be spaced by one pixel unit, and one pixel unit may include three sub-pixels or four sub-pixels arranged in the first direction X, that is, in the first direction X, a first adapt electrode Vinit 10 and a second adapt electrode Vinit 20 may be located between two adjacent pixel units.

In an exemplary implementation, as shown in FIG. 10c, a schematic diagram of a planar structure of a semiconductor layer of three columns of sub-pixels (an N1-th column, an N2-th column, and an N3-th column) located on a side of the Q1-th column sub-pixels away from the Q2-th column sub-pixels in the first direction X, shield layers of the N1-th column to the Nth column of sub-pixels is the same as shield layer structures of the Q1-th column to the Q3-th column of sub-pixels. In an exemplary implementation, FIG. 10c differs from FIG. 10b in that the first initial signal lines Vinit1 are not provided with the first adapt electrodes Vinit10, and the second initial signal lines Vinit2 are not provided with the second adapt electrodes Vinit20.

In an exemplary implementation, shapes of the semiconductor layers in a plurality of sub-pixel rows may be the same, and shapes of active layers of first transistors T1 to seventh transistors T7 in a plurality of sub-pixel columns may be the same.

In an exemplary implementation, the semiconductor layer may be made of polysilicon (p-Si), i.e., the first transistors T1 to the seventh transistors T7 may be LTPS thin film transistors. In an exemplary implementation, patterning the first semiconductor thin film through the patterning process may include: forming an amorphous silicon (a-si) thin film on the first insulation thin film, dehydrogenating the amorphous silicon thin film, and crystallizing the dehydrogenated amorphous silicon thin film to form a polysilicon thin film. Subsequently, the polysilicon thin film is patterned to form the pattern of the semiconductor layer.

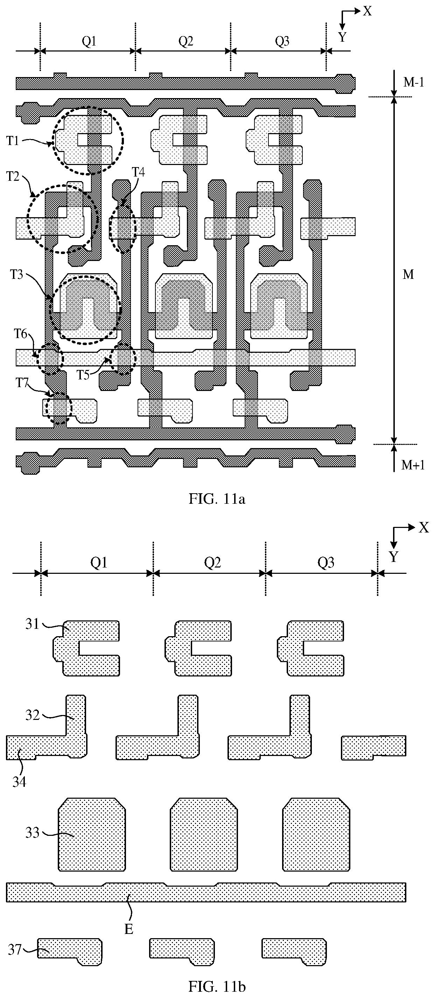

(104) A pattern of a first conductive layer is formed. In an exemplary implementation, forming a pattern of a first conductive layer may include: sequentially depositing a second insulating thin film and a first conductive thin film on the base substrate on which the above-mentioned pattern is formed, and patterning the first conductive thin film through a patterning process to form a second insulation layer that covers a pattern of the semiconductor layer and form a pattern of the first conductive layer disposed on the second insulation layer, as shown in FIG. 11a and FIG. 11b, and FIG. 11b is a planar schematic diagram of the first conductive layer in FIG. 11a. In an exemplary implementation, the first conductive layer may be referred to as a first gate metal (GATE1) layer.

In an exemplary implementation, the pattern of the first conductive layer may at least include: a control electrode 31 of a first transistor T1, a control electrode 32 of a second transistor T2, a first plate 33 of a storage capacitor (which may be served as a control electrode of a third transistor T3), a control electrode 34 of a fourth transistor T4, a light emitting control line E, and a control electrode 37 of a seventh transistor T7. A main body portion of the light emitting control line E may extend in the first direction X. In a same sub-pixel, a control electrode 31 of a first transistor T1, a control electrode 32 of a second transistor T2, a first plate 33 of a storage capacitor, and a light emitting control line E may be arranged in the second direction Y.

In an exemplary implementation, in the second direction Y, the control electrode 31 of the first transistor T1 may be located on one side of the control electrode 32 of the second transistor T2 away from the first plate 33 of the storage capacitor, the control electrode 32 of the second transistor T2 and the light emitting control line E are located on both sides of the first plate 33 of the storage capacitor, and the control electrode 37 of the seventh transistor T7 may be located on one side of the light emitting control line E away from the first plate 33 of the storage capacitor.

Taking a sub-pixel in the M-th row and in the Q2-th column as an example, in the second direction Y, in a same sub-pixel, a control electrode 31 of a first transistor T1 may be located on a side of a control electrode 32 of a second transistor T2 close to the sub-pixels of the (M-1)-th row, the control electrode 32 of the second transistor T2 may be located between the control electrode 31 of the first transistor T1 and a first plate 33 of a storage capacitor, and the light emitting control line E may be located on a side of the first plate 33 of the storage capacitor close to the sub-pixels of the (M+1)-th row, a control electrode 37 of a seventh transistor T7 may be located on a side of the light emitting control line E close to the sub-pixels of the (M+1)-th row; in the first direction X, a control electrode 34 of a fourth transistor T4 may be located on a side of the control electrode 32 of the second transistor T2 close to the Q3-th column sub-pixels, and the control electrode 34 of the fourth transistor T4 and a control electrode 32 of a second transistor T2 in the Q3-tjh column sub-pixels may be formed into an integral structure.

In an exemplary implementation, a shape of the control electrode 31 of the first transistor T1 may be substantially a shape of "U" (e.g., a shape of "U" rotated clockwise by 90°), and a region where an orthographic projection of the control electrode 31 of the first transistor T1 on the base substrate is overlapped with orthographic projections of two channel regions of the active layer 21 of the first transistor T1 on the base substrate may form a double-gate structure of the first transistor T1; a shape of the control electrode 32 of the second transistor T2 may be a shape of "L", and a region where an orthographic projection of the control electrode 32 of the second transistor T2 on the base substrate is overlapped with orthographic projections of two channel regions of the active layer 22 of the second transistor T2 on the base substrate may form a double-gate structure of the second transistor T2; the control electrode 34 of the fourth transistor T4 and the control electrode 37 of the seventh transistor T7 may be in a shape of a strip extending in the first direction X. The control electrode 34 of the fourth transistor T4 and a control electrode 32 of a second transistor T2 located in an adjacent sub-pixel column in a same row of sub-pixels may be formed into an integral structure. An orthographic projection of the control electrode 34 of the fourth transistor T4 on the base substrate is overlapped with an orthographic projection of a channel region of the active layer 24 of the fourth transistor T4 on the base substrate. An orthographic projection of the control electrode 37 of the seventh transistor T7 on the base substrate is overlapped with an orthographic projection of a channel region of the active layer 27 of the seventh transistor T7 on the base substrate.

In an exemplary implementation, the first plate 36 may be located between the light emitting control line 35 and the control electrode 32 of the fourth transistor T2, the first plate 33 may be in a rectangular shape, corners of the rectangular may be chamfered, and an orthographic projection of the first plate 36 on the base substrate is overlapped with an orthographic projection of the active layer of the third transistor T3 on the base substrate. In an exemplary implementation, the first plate 33 may simultaneously serve as a plate of the storage capacitor and the control electrode of the third transistor T3.

In an exemplary implementation, a region where the light emitting control line 35 is overlapped with the active layer of the fifth transistor T5 serves as the control electrode of the fifth transistor T5, and a region where the light emitting control line 35 is overlapped with the active layer of the sixth transistor T6 serves as the control electrode of the sixth transistor T6.

In an exemplary implementation, shapes of first conductive layers in a plurality of sub-pixel rows may be the same, and shapes of first conductive layers in a plurality of sub-pixel columns may be the same.

In an exemplary implementation, the light emitting control line E may be designed with an equal width or with non-equal widths, thereby not only a layout of a pixel structure may be facilitated, but also a parasitic capacitance between signal lines may be reduced.

In an exemplary implementation, after the pattern of the first conductive layer is formed, a conductive treatment may be performed on the semiconductor layer by using the first conductive layer as a shield. A region of the semiconductor layer, which is shielded by the first conductive layer, forms channel regions of the first transistor T1 to the seventh transistor T7, and a region of the semiconductor layer, which is not shielded by the first conductive layer, is made to be conductive, that is, first regions and second regions of the active layer 21 of the first transistor T1 to the active layer 27 of the seventh transistor T7 are all made to be conductive.

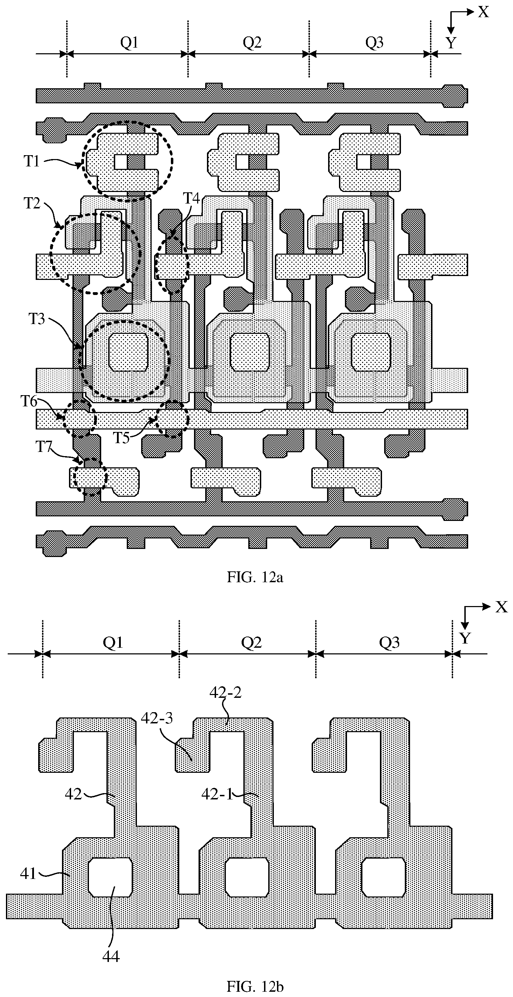

(105) A pattern of a second conductive layer is formed. In an exemplary implementation, forming the pattern of the second conductive layer may include: depositing sequentially a third insulation thin film and a second conductive thin film on the base substrate where the aforementioned patterns are formed, and patterning the second conductive thin film through a patterning process to form a third insulation layer covering the first conductive layer and the pattern of the second conductive layer disposed on the third insulation layer, as shown in FIG. 12a and FIG. 12b, FIG. 12a is a diagram of a planar structure of three columns of sub-pixels from the Q1-th column to the Q3-th column in one sub-pixel row (i.e., three sub-pixels), and FIG. 12b is a planar schematic view of the second conductive layer in FIG. 12a. In an exemplary implementation, the second conductive layer may be referred to as a second gate metal (GATE2) layer.

In an exemplary implementation, the pattern of the second conductive layer includes at least a second plate 41 of the storage capacitor and a first shield electrode 42. The second plate 41 of the storage capacitor serves as the other plate of the storage capacitor. In the second direction Y, in a same sub-pixel, the first connection electrode 42 is located on one side of the second plate 41, for example, in the same sub-pixel, the first connection electrode 42 and the second plate 41 of the storage capacitor are arranged sequentially in the second direction Y.

In an exemplary implementation, a profile of the second plate 41 may be in a shape of a rectangle whose corners may be chamfered, there is an is overlapped with area between an orthographic projection of the second plate 41 on the base substrate and an orthographic projection of the first plate 33 on the base substrate, and the first plate 33 and the second plate 41 form the storage capacitor of the pixel drive circuit. The second plate 41 is provided with an opening 43, and the opening 43 may be located in the middle of the second plate 41. The opening 43 may be rectangular and enables the second plate 41 to form an annular structure. The opening 43 exposes the third insulation layer covering the first plate 33, and an orthographic projection of the first plate 33 on the base substrate contains an orthographic projection of the opening 43 on the base substrate. In an exemplary embodiment, the opening 43 is configured to accommodate a ninth via subsequently formed, the ninth via is located in the opening 43 and exposes the first plate 33, so that a second electrode of the first transistor T1 subsequently formed is connected to the first plate 33.

In an exemplary implementation, a shape of the first shield electrode 42 may be a shape of "L", and in a same sub-pixel, the first shield electrode 42 and the second plate 41 may be formed into an integral structure, and an orthographic projection of the first shield electrode 42 on the base substrate is not overlapped with orthographic projections of the control electrode 31 of the first transistor T1, the control electrode 32 of the second transistor T2, and the control electrode 34 of the fourth transistor T4 on the base substrate. In an exemplary implementation, a shape of the control electrode 31 of the first transistor T1 may be substantially a shape of "U" rotated clockwise by 90°, a shape of the control electrode 32 of the second transistor T2 may be a shape of "L" rotated counter-clockwise by 90°, a shape of the first shield electrode 42 may be a shape of "L" rotated counter-clockwise by 180°, the first shield electrode 42 may include first portion 42-1, second portion 42-2 and third portion 42-3 which are connected to each other, and in a same sub-pixel and in the first direction X, an orthographic projection of the first portion 42-1 on the base substrate may be located between an orthographic projection of the control electrode 32 of the second transistor T2 on the base substrate and an orthographic projection of the control electrode 34 of the fourth transistor T4 on the base substrate, the third portion 42-3 may be located on a side of the second portion 42-2 away from the first portion 42-1, at least part of the orthographic projection of the control electrode 32 of the second transistor T2 on the base substrate may be located between the orthographic projections of the first portion 42-1, and the third portion 42-3 on the base substrate, and in the second direction Y, an orthographic projection of the second portion 42-2 on the base substrate may be located between an orthographic projection of the control electrode 31 of the first transistor T1 on the base substrate and the orthographic projection of the control electrode 32 of the second transistor T2 on the base substrate. The orthographic projection of the third portion 42-3 on the base substrate is at least partially overlapped with the orthographic projection of the active layer 22 of the second transistor T2 on the base substrate, so that the active layer 22 of the second transistor T2 is shielded, and the stability of the second transistor T2 can be improved.

In an exemplary implementation, in a same sub-pixel row, two adjacent second plates 41 are connected to each other, so that a plurality of second plates 41 located in the same sub-pixel row have substantially the same potential, and it is possible to ensure that the second plates of the storage capacitors of adjacent sub-pixels have the same potential, which is beneficial to improving the display uniformity of the panel, avoiding poor display of the display substrate, and ensuring the display effect of the display substrate.

In an exemplary implementation, shapes of the second conductive layers in a plurality of sub-pixel rows may be the same, and shapes of the second conductive layers in a plurality of sub-pixel columns may be the same.

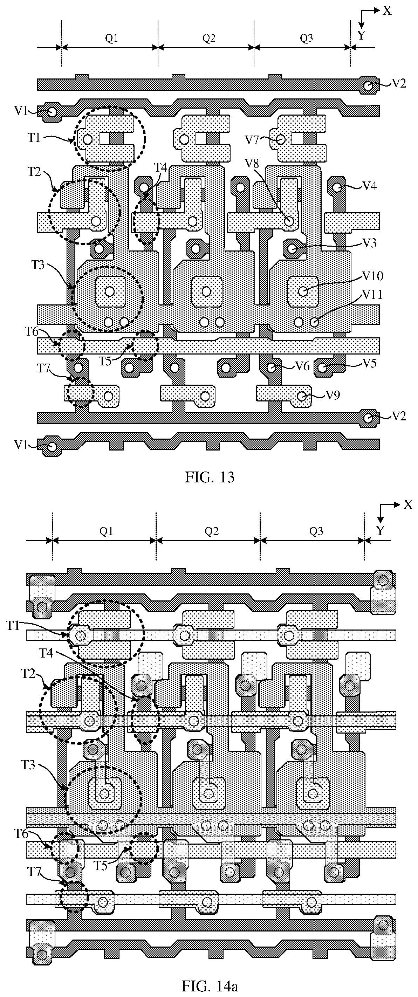

(106) A pattern of a fourth insulation layer is formed. In an exemplary embodiment, forming the pattern of the fourth insulation layer may include: depositing a fourth insulation thin film on the base substrate on which the aforementioned patterns are formed, patterning the fourth insulation thin film by using a patterning process, to form a fourth insulation layer covering the second conductive layer, and a plurality of vias are provided on the fourth insulation layer, as shown in FIG. 13, a diagram of a planar structure of three sub-pixels.

In an exemplary implementation, the plurality of vias in each sub-pixel at least include: a first via V1, a second via V2, a third via V3, a fourth via V4, a fifth via V5, a sixth via V6, a seventh via V7, an eighth via V8, a ninth via V9, a tenth via V10, and an eleventh via V11.

In an exemplary implementation, an orthogonal projection of the first via V1 on the base substrate is within a range of an orthogonal projection of a first initial signal line Vinit1 on the base substrate (e.g., the orthogonal projection of the first via V1 on the base substrate may be within a range of an orthogonal projection of a first transition electrode Vinit10 on the first initial signal line Vinit1 on the base substrate). The fourth insulation layer, the third insulation layer, and the second insulation layer within the first via V1 are etched away, to expose a surface of the first initial signal line Vinit1 (e.g., to expose a surface of the first transition electrode Vinit10 on the first initial signal line Vinit1). The first via V1 is configured such that a first initial signal connection line to be formed subsequently is electrically connected to the first initial signal line Vinit1 through this via.

In an exemplary implementation, an orthogonal projection of the second via V2 on the base substrate is within a range of an orthogonal projection of a second initial signal line Vinit2 on the base substrate (e.g., the orthogonal projection of the second via V2 on the base substrate may be within a range of an orthogonal projection of a second transition electrode Vinit20 on the second initial signal line Vinit2 on the base substrate). The fourth insulation layer, the third insulation layer, and the second insulation layer within the second via V2 are etched away, to expose a surface of the second initial signal line Vinit2 (e.g., to expose a surface of the second transition electrode Vinit20 on the second initial signal line Vinit2). The second via V2 is configured such that a second initial signal connection line to be formed subsequently is electrically connected to the second initial signal line Vinit2 through this via.

In an exemplary implementation, an orthographic projection of the third via V3 on the base substrate may be located within a range of an orthographic projection of the active layer 22 of the second transistor T2 on the base substrate. The fourth insulation layer, the third insulation layer, and the second insulation layer within the third via V3 are etched away, to expose a surface of the first region 22-1 of the active layer 22 of the second transistor T2 (which is also the second region 21-2 of the active layer 21 of the first transistor T1). The third via V3 is configured such that a second electrode of the first transistor T1 to be formed subsequently is connected to the active layer 21 of the first transistor T1 through this via, and a first electrode of the second transistor T2 to be formed subsequently is connected to the active layer 22 of the second transistor T2 through this via.

In an exemplary implementation, an orthographic projection of the fourth via V4 on the base substrate is within a range of an orthographic projection of the active layer 24 of the fourth transistor T4 on the base substrate. The fourth insulation layer, the third insulation layer, and the second insulation layer within the fourth via V4 are etched away, to expose the first region 24-1 of the active layer 24 of the fourth transistor T4. The fourth via V4 is configured such that the first electrode of the fourth transistor T4 to be formed subsequently is connected to the active layer 24 of the fourth transistor T4 through this via.

In an exemplary implementation, an orthographic projection of the fifth via V5 on the base substrate is located within a range of an orthographic projection of the active layer 25 of the fifth transistor T5 on the base substrate. The fourth insulation layer, the third insulation layer and the second insulation layer within the fifth via V5 are etched away, to expose a surface of the first region 25-1 of the active layer 25 of the fifth transistor T5. The fifth via V5 is configured such that the first electrode of the fifth transistor T5 to be formed subsequently is connected to the active layer 25 of the fifth transistor T5 through this via.

In an exemplary implementation, an orthographic projection of the sixth via V6 on the base substrate is located within a range of an orthographic projection of the active layer 26 of the sixth transistor T6 on the base substrate. The fourth insulation layer, the third insulation layer, and the second insulation layer within the sixth via V6 are etched away, to expose a surface of a second region 26-2 of the active layer 26 of the sixth transistor T6 (which is also a second region 27-2 of the active layer 27 of the seventh transistor T7). The sixth via V6 is configured such that the second electrode of the sixth transistor T6 to be formed subsequently is connected to the active layer 26 of the sixth transistor T6 through this via, and the second electrode of the seventh transistor T7 to be formed subsequently is connected to the active layer 27 of the seventh transistor T7 through this via.

In an exemplary implementation, an orthographic projection of the seventh via V7 on the base substrate is within a range of an orthographic projection of the control electrode 31 of the first transistor T1 on the base substrate. The fourth insulation layer and the third insulation layer within the seventh via V7 are etched away, to expose a surface of the control electrode 31 of the first transistor T1. The seventh via V7 is configured such that a first reset control line to be formed subsequently is connected to the control electrode 31 of the first transistor T1 through this via.

In an exemplary implementation, an orthographic projection of the eighth via V8 on the base substrate is within a range of an orthographic projection of the control electrode 32 of the second transistor T2 on the base substrate. The fourth insulation layer and the third insulation layer within the eighth via V8 are etched away, to expose a surface of the control electrode 32 of the second transistor T2. The eighth via V8 is configured such that a scan signal line to be formed subsequently is connected to the control electrode 32 of the second transistor T2 through this via.

In an exemplary implementation, an orthographic projection of the ninth via V9 on the base substrate is within a range of an orthographic projection of the control electrode 37 of the seventh transistor T7 on the base substrate The fourth insulation layer and the third insulation layer within the ninth via V9 are etched away, to expose a surface of the control electrode 37 of the seventh transistor T7. The ninth via V9 is configured such that the first reset control line to be formed subsequently is connected to the control electrode 37 of the seventh transistor T7 through this via.

In an exemplary implementation, an orthographic projection of the tenth via V10 on the base substrate may be located within a range of an orthographic projection of an opening 44 on the base substrate. The fourth insulation layer and the third insulation layer within the tenth via V10 are etched away, to expose a surface of the first plate 33. The tenth via V10 is configured such that the second electrode of the first transistor T1 (i.e., the first electrode of the second transistor T2) to be formed subsequently is connected to the first plate 33 through this via.

In an exemplary implementation, an orthographic projection of the eleventh via V11 on the base substrate is located within a range of an orthographic projection of the second plate 41 on the base substrate. The fourth insulation layer within the eleventh via V11 is etched away, to expose a surface of the second plate 41. The eleventh via V11 is configured such that the first power supply connection line to be formed subsequently is connected to the second plate 41 through this via. In an exemplary implementation, there may be a plurality of eleventh vias V11 which serve as power supply vias, and the plurality of eleventh vias V11 may be sequentially arranged in the second direction Y or the first direction X, thereby increasing the reliability of the connection between the first power supply connection line and the second plate 41.

In an exemplary implementation, the pattern of the fourth insulation layer may also include a power supply adapt via located in the bezel area 300, and as shown in FIG. 8c, the first power supply signal supply line VDDO (to be formed subsequently) located in the bezel area 300 may be electrically connected to the shield adapt line BSML located in the bezel area 300 in the shield layer BSM through the power supply adapt via.

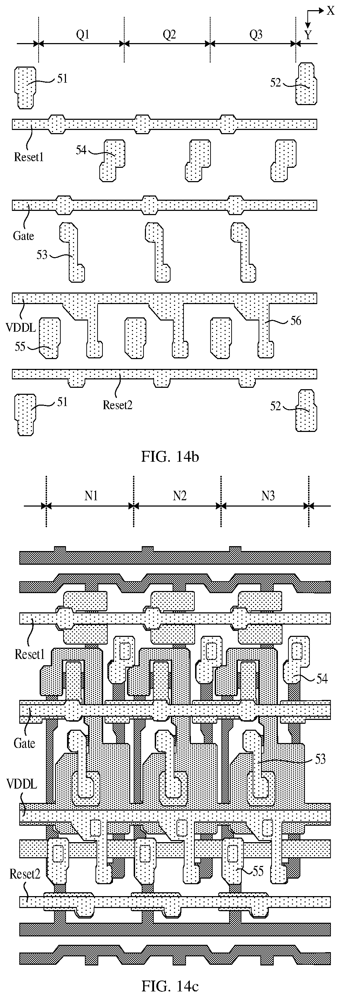

(107) A pattern of a third conductive layer is formed. In an exemplary implementation, forming the pattern of the third conductive layer may include: depositing a third conductive thin film on the base substrate on which the aforementioned patterns are formed, patterning the third conductive thin film by using a patterning process, to form the pattern of the third conductive layer disposed on the fourth insulation layer, as shown in FIGS. 14a to 14c, FIG. 14a is a diagram of a plane structure of three columns of sub-pixels from the Q1-th column to the Q3-th column in a row of sub-pixels (i.e., three sub-pixels), FIG. 14b is a schematic diagram of a plane structure of the third conductive layer in FIG. 14a, and FIG. 14c is diagram of a plane structure of three columns of sub-pixels from the N1-th column to the N3-th column in a row of sub-pixels (i.e., three sub-pixels). In an exemplary implementation, the third conductive layer may be referred to as a first source drain metal (SD1) layer.

In an exemplary implementation, the pattern of the third conductive layer at least includes: a first reset control line Reset1, a scan signal line Gate, a second reset control line Reset2, a first power supply connection line VDDL, first connection electrodes 51, second connection electrodes 52, third connection electrodes 54, fourth connection electrodes 54, fifth connection electrodes 55, the first power supply signal supply line VDDO, the second power supply lines VSS, wherein the scan signal line Gate, the first reset control line Reset1, the second reset control line Reset2, and a main body portion of the first power supply connection line VDDL may extend in the first direction X, and in a same row of sub-pixels, the first reset control line Reset1, the scan signal line Gate, the first power supply connection line VDDL, and the second reset control line Reset2 may be arranged sequentially in the second direction Y.

In an exemplary implementation, the first reset control line Reset1 may be configured to be electrically connected to control electrodes 31 of a plurality of first transistors T1 in a row of sub-pixels through a plurality of seventh vias V7, so that a first reset control signal may be provided to the plurality of first transistors T1 in a row of sub-pixels; the scan signal line Gate may be configured to be electrically connected to control electrodes 32 of a plurality of second transistors T2 in a row of sub-pixels through the eighth via V8, and since the control electrodes 32 of the second transistors T2 and the control electrodes 34 of the fourth transistors T4 are interconnected, the scan signal line Gate may provide a scan signal to the plurality of second transistors T2 and the plurality of fourth transistors T4 in a row of sub-pixels; the second reset control line Reset2 may be configured to be electrically connected to control electrodes 37 of a plurality of seventh transistors T7 in a row of sub-pixels through a plurality of ninth vias V9, so that the second reset control signal may be provided to the plurality of seventh transistors T7 in a row of sub-pixels.

In an exemplary implementation, a plurality of power supply connection electrodes 56 may be disposed on the first power supply connection line VDDL. In the second direction Y, the plurality of power supply connection electrodes 56 may be disposed on a side of the first power supply connection line VDDL away from the scan signal line Gate. A shape of a power supply connection electrode 56 may be substantially a shape of a polyline extending in the second direction Y. The power supply connection electrodes 56 may be configured to be electrically connected to active layers 25 of a plurality of fifth transistors T5 in a row of sub-pixels through a plurality of sixth vias V6, and with a plurality of second plates 41 in a row of sub-pixels through a plurality of eleventh vias V11, such that the first power supply connection line VDDL may provide a first power supply signal to the plurality of fifth transistors T5 and the plurality of second plates 41 in a row of sub-pixels, such that the second plates 41 have substantially the same potential as the first electrodes of the fifth transistors T1.

In an exemplary implementation, a first connection electrode 51 and a second connection electrode 52 may be substantially rectangular in shape, the first connection electrode 51 may be connected to the first initial signal line Vinit1 through the first via V1 (e.g., connected to the first adapt electrode Vinit10 disposed on the first initial signal line Vinit1), and the second connection electrode 52 may be connected to the second initial signal line Vinit2 through the second via V2 (e.g., connected to the second adapt electrode Vinit20 disposed on the second initial signal line Vinit2).

In an exemplary implementation, a shape of a third connection electrode 53 may be a shape of a polyline extending substantially in the second direction Y, the third connection electrode 53 at one end is connected to the first region 22-1 of the active layer 22 of the second transistor T2 (which is also the second region 21-2 of the active layer 21 of the first transistor T1) through the third via V3, and at the other end is connected to the first plate 33 of the storage capacitor through the tenth via V10, so that the first plate 33, the second electrode of the first transistor T1, and the first electrode of the second transistor T2 can have the same potential. In an exemplary embodiment, a third connection electrode 53 may serve as a second electrode of a first transistor T1 and a first electrode of a second transistor T2. In a same sub-pixel row, a plurality of third connection electrodes 53 may be located between the first power supply connection line VDDL and the scan signal line Gate in the second direction Y.

In an exemplary implementation, a shape of a fourth connection electrode 54 may be a shape of a polyline extending substantially in the second direction Y, and the fourth connection electrode 54 may be connected to the first region 24-1 of the active layer 24 of the fourth transistor T4 through the fourth via V4. In an exemplary embodiment, the fourth connection electrode 54 may serve as the second electrode of the fourth transistor T4. In a same sub-pixel row, a plurality of fourth connection electrodes 54 may be located between the first reset control line Reset1 and the scan signal line Gate in the second direction Y.

In an exemplary implementation, a shape of a fifth connection electrode 55 may be substantially rectangular in shape, and the fifth connection electrode 55 may be connected to the second region 26-2 of the active layer 26 of the sixth transistor T6 (which is also the second region 27-2 of the active layer 27 of the seventh transistor T7) through the fifth via V5. In an exemplary embodiment, the fifth connection electrode 55 may serve as the second electrode of the sixth transistor T6 and the second electrode of the seventh transistor T7. In an exemplary implementation, in a same row of sub-pixels, the fifth connection electrodes 55 may be located between the main body portion of the first power supply connection line VDDL and the second reset control line Reset2 in the second direction Y, and the plurality of fifth connection electrodes 55 and the plurality of power supply connection electrodes 56 may be alternately arranged in the first direction X.

In an exemplary implementation, as shown in FIG. 14c, a schematic diagram of a planar structure of three columns of sub-pixels (the N1-th column, the N2-th column, and the N3-th column) located on a side of the Q1-th column sub-pixel away from the Q2-th column sub-pixel in the first direction X. In an exemplary implementation, the difference between FIG. 14c and FIG. 14a is that the first connection electrodes 51 and the second connection electrodes 52 are not disposed in the third conductive layer.

In an exemplary implementation, as shown in FIGS. 5a and 8a, the first power supply signal supply line VDDO may be located in the bezel area 300 and disposed around the display area 100, and the first power supply signal supply line VDD0and the first power supply connection lines VDDL located in the display area 100 may be formed into an integral structure. On a plane parallel to the display substrate, the second power supply lines VSS are located on a side of the first power supply signal supply line VDDO away from the display area 100.

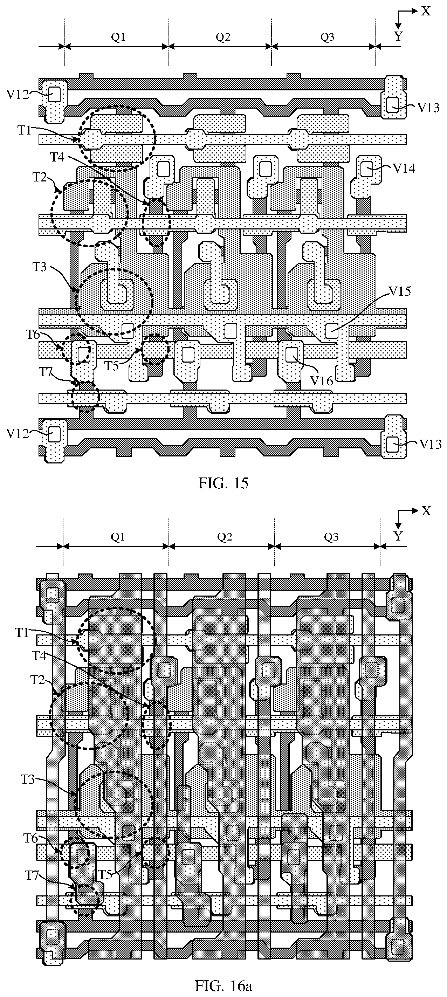

(108) Patterns of a fifth insulation layer and a first planarization layer are formed. In an exemplary implementation, forming the patterns of the fifth insulation layer and the first planarization layer may include: firstly depositing a fifth insulation thin film on the base substrate on which the aforementioned patterns are formed, then coating a first planarization thin film, patterning the first planarization thin film and the first planarization thin film by using a patterning process, to form the fifth insulation layer covering the third conductive layer and a first planarization layer disposed on the fifth insulation layer, and the fifth insulation layer and the first planarization layer are provided with a plurality of vias, as shown in FIG. 15, which is a diagram of a planar structure of three sub-pixels.

In an exemplary implementation, a plurality of vias in each sub-pixel include at least: a twelfth via V12, a thirteenth via V13, a fourteenth via V14, a fourth fifth via V15, a sixteenth via V16, and a seventeenth via V17.

In an exemplary implementation, an orthographic projection of the twelfth via V12 on the base substrate is located within a range of an orthographic projection of a first connection electrode 51 on the base substrate. The first planarization layer and the fifth insulation layer within the twelfth via V12 are etched away, to expose a surface of the first connection electrode 51. The twelfth via V12 is configured so that a first initial signal connection line to be formed subsequently is connected to the first initial connection electrode 51 through this via.

In an exemplary implementation, an orthographic projection of the thirteenth via V13 on the base substrate is within a range of an orthographic projection of a second connection electrode 52 on the base substrate. The first planarization layer and the fifth insulation layer within the thirteenth via V13 are etched away, to expose a surface of the second connection electrode 52. The sixteenth via V13 is configured such that a second initial signal connection line to be formed subsequently is connected to the second connection electrode 52 through this via.

In an exemplary implementation, an orthographic projection of the fourteenth via V14 on the base substrate is located within a range of an orthographic projection of a fourth connection electrode 54 on the base substrate. The first planarization layer and the fifth insulation layer within the fourteenth via V14 are etched away, to expose a surface of the fourth connection electrode 54. The fourteenth via V14 is configured such that a data signal line to be formed subsequently is connected to the fourth connection electrode 54 through this via. In an exemplary implementation, an orthographic projection of the fifteenth via V15 on the base substrate is within a range of an orthographic projection of the first power supply connection line VDDL (e.g., the first power supply connection electrode 56 on the first power supply connection VDDL) on the base substrate. The fifth insulation layer and the first planarization layer within the fifteenth via V15 are etched away, to expose a surface of the first power supply connection line VDDL. The fifteenth via V15 is configured such that the first power supply line to be formed subsequently is connected to the first power supply connection line 73 through this via.

In an exemplary implementation, an orthographic projection of the sixteenth via V16 on the base substrate is located within a range of an orthographic projection of a fifth connection electrode 55 on the base substrate. The first planarization layer and the fifth insulation layer within the sixteenth via V16 are etched away, to expose a surface of the fifth connection electrode 55. The sixteenth via V16 is configured such that the anode connection electrode to be formed subsequently is connected to the fifth connection electrode 55 through this via.

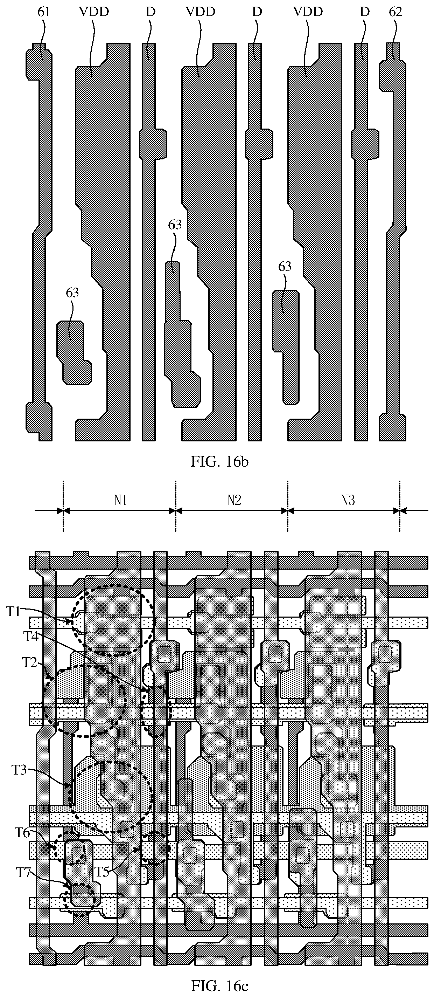

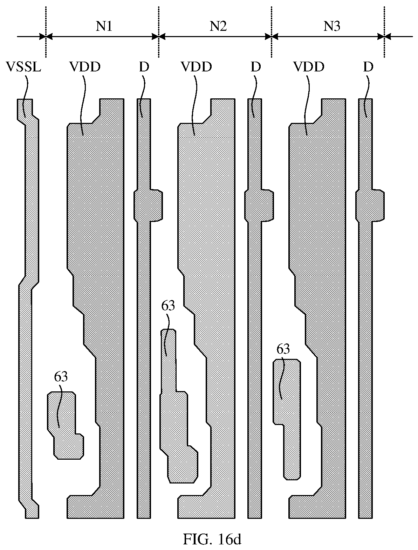

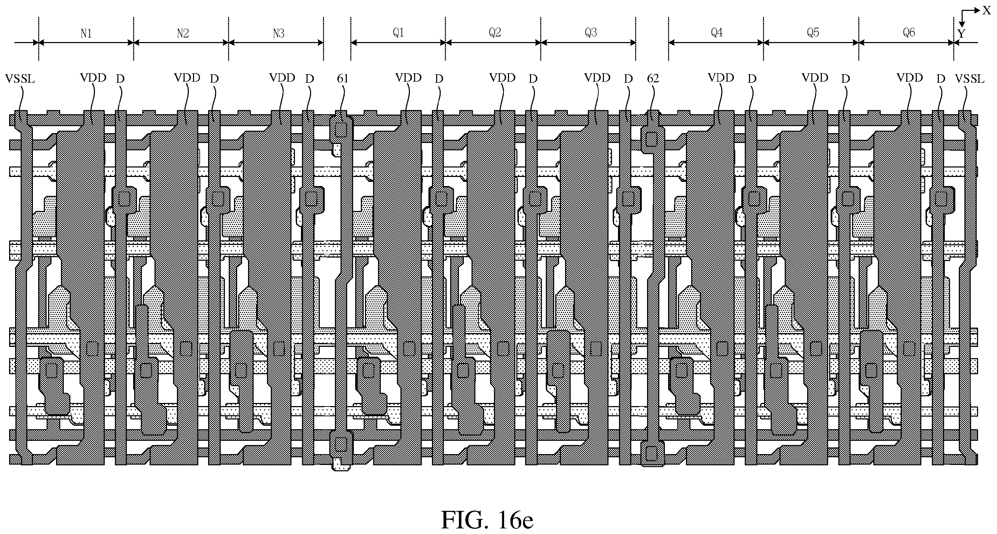

(109) A pattern of a fourth conductive layer is formed. In an exemplary embodiment, forming the pattern of the fourth conductive layer may include: depositing a fourth conductive thin film on the base substrate on which the aforementioned patterns are formed, patterning the fourth conductive thin film by using a patterning process, to form a fourth conductive layer disposed on the sixth insulation layer, as shown in FIG. 16a to FIG. 16d. FIG. 16a is a diagram of a planar structure of three columns of sub-pixels from the Q1-th column to the Q2-th column in a row of sub-pixels (i.e., three sub-pixels), FIG. 16b is a planar schematic view of the fourth conductive layer in FIG. 16a, FIG. 16c is a diagram of a planar structure of three columns of sub-pixels from the N1-th column to the N3-th column in a row od sub-pixels ((i.e., three sub-pixels), and FIG. 16d is a planar schematic view of the fourth conductive layer in FIG. 16c. In an exemplary implementation, the fourth conductive layer may be referred to as a second source drain metal (SD2) layer.

In an exemplary embodiment, the fourth conductive layer includes at least: first power supply lines VDD, data signal lines D, a first initial signal connection line 61, a second initial signal connection line 62, anode connection electrodes 63, second power supply connection lines VSSL, second power supply lines VSS, a second power supply adapt lines VSSZ1, and drive signal connection lines GOAL. In an exemplary embodiment, an anode connection electrode 63 is an anode connection electrode of a light emitting element.

In an exemplary embodiment, a data signal line D may be in a shape of a polyline or a strip of which a main body portion extends in the second direction Y, and the data signal line D is connected to the fourth connection electrode 54 through the fourteenth via V14. Since the fourth connection electrode 54 is connected to the first region 24-1 of the active layer 24 of the fourth transistor T4 through a via, connection between the data signal line D and the first electrode of the fourth transistor T4 is achieved, and a data signal is written into the fourth transistor T4.

In an exemplary implementation, a first power supply line VDD is in a shape of a polyline of which a main body portion extends in the second direction Y, and the first power supply line 82 is connected to the first power supply connection line VDDL through the fifteenth via V15. Since the first power supply connection line VDD is connected to the second plate 41 through a via, connection between the first power supply line VDD and the second plate 41 is achieved, and a power supply signal is written into the second plate 41. Since the first power supply connection line VDD is connected to the first region 25-1 of the active layer 25 of the fifth transistor T5 through a via, connection between the first power supply line VDD and the first electrode of the fifth transistor T5 is achieved, and a power supply signal is written into the fifth transistor T5.

In an exemplary embodiment, a first initial signal connection line 61 may be in a shape of a polyline of which a main body portion extends in the second direction Y, and the first initial signal connection line 61 may be connected to the first connection electrode 51 through the twelfth via V12. Since the first connection electrode 51 is connected to the first initial signal line Vinit1 through a via, connection between the first initial signal connection line 61 and the first initial signal line Vinit1 is achieved. Since the first initial signal connection line 61 can be electrically connected to a plurality of first initial signal lines Vinit1 arranged in the second direction Y, initial signals provided by a plurality of first initial signal lines Vinit1 can be substantially the same. Since the first initial signal lines Vinit1 is connected to the first regions 21-1 of the first transistors T1, initial signals obtained by the first transistors T1 in a plurality of rows of sub-pixels can be substantially the same, thereby improving the display uniformity of the display substrate.

In an exemplary embodiment, the second initial signal connection line 62 may be in a shape of a polyline of which a main body portion extends in the second direction Y, and the second initial signal connection line 62 may be connected to the second connection electrode 52 through the thirteenth via V13. Since a second connection electrode 52 is connected to a second initial signal line Vinit2 through a via, connection between the second initial signal connection line 62 and the second initial signal line Vinit2 is achieved. Since the second initial signal connection line 62 can be electrically connected to a plurality of second initial signal lines Vinit2 arranged in the second direction Y, initial signals provided by the plurality of second initial signal lines Vinit2 can be substantially the same. Since the second initial signal lines Vinit2 are connected to the first regions 27-1 of the seventh transistors T7, the initial signals obtained by the seventh transistors T7 in a plurality of rows of sub-pixels can be substantially the same, thereby improving the display uniformity of the display substrate.

In an exemplary embodiment, the anode connection electrode 63 is connected to the fifth connection electrode 55 through the sixteenth via V16. Since the fifth connection electrode 55 is connected to the second region 26-2 of the active layer 26 of the sixth transistor T6 (which is also the second region 27-2 of the active layer 27 of the seventh transistor T7) through a via, connections between the anode connection electrode 63 and the second electrode of the sixth transistor T6 as well as the second electrode of the seventh transistor are achieved.

In an exemplary implementation, as shown in FIGS. 16c to 16e, a second power supply connection line VSSL may be in a shape of a polyline extending in the second direction Y. In an exemplary implementation, the second power supply connection line VSSL, the first initial signal connection line 61, and the second initial signal connection line 62 may be arranged periodically in the first direction X, and in one period, the second power supply connection line VSSL and the first initial signal connection line 61 may be spaced by a column of pixel units, and the first initial signal connection line 61 and the second initial signal connection line 62 may be spaced by a column of pixel units. In the first direction X, the second power supply connection line VSSL may be located between two adjacent columns of pixel units, the first initial signal connection line 61 may be located between two adjacent columns of pixel units, and the second initial signal connection line 62 may be located between two adjacent columns of pixel units. Embodiments of the present disclosure are not limited to this arrangement. For example, the second power supply connection line VSSL, the first initial signal line 61, and the second initial signal line 62 may be located between two adjacent columns of sub-pixels, such as located between two adjacent sub-pixel columns in a column of pixel units.

In an exemplary implementation, as shown in FIG. 6e, in one period, the two adjacent second power supply connection lines VSSL may be spaced by three pixel units, the two adjacent first initial signal connection lines 61 may be spaced by three pixel units, and the two adjacent second initial signal connection lines 62 may be spaced by three pixel units, i.e., in one period, the quantity of the second power supply connection lines VSSL: the quantity of the first initial signal connection lines 61: the second initial signal connection lines 62 is 1: 1: 1, and the second power supply connection lines VSSL, the first initial signal connection lines 61, and the second initial signal connection lines 62 may be arranged sequentially in the first direction X. In an exemplary implementation, in the first direction X, a period distance of the second power supply connection line VSSL, the first initial signal connection line 61, and the second initial signal connection line 62 is not limited to three pixel units, but may be more than three pixel units, for example, the period distance may be four pixel units or 3.5 pixel units, which is not limited in the present disclosure.

In an exemplary implementation, in one period, the quantity of the second power supply connection lines VSSL: the quantity of the first initial signal connection lines 61: the quantity of the second initial signal connection lines 62 is 2: 2: 1, and in one period, the first initial signal connection lines 61, the second initial signal connection lines 62, the second power supply connection lines VSSL, the first initial signal connection lines 61, and the second initial signal connection lines 62 may be arranged sequentially in the first direction X, and the distance in one period may be, but not limited to, five pixel units.

In an exemplary implementation, the second power supply lines VSS located in the fourth conductive layer may be electrically connected to the second power supply lines VSS located in the third conductive layer through vias to form a double-layer structure, or the second power supply lines VSS located in the fourth conductive layer may be directly electrically connected to the second power supply lines VSS located in the third conductive layer to form a double-layer structure, orthographic projections of the second power supply lines VSS located in the fourth conductive layer on the base substrate are at least partially overlapped with orthographic projections of the second power supply lines VSS located in the third conductive layer on the base substrate; as shown in FIGS. 5a and 5b, in directions parallel to the plane on which the display substrate is located, the second power supply adapt lines VSSZ1 may be located between the second power supply lines VSS and the first power supply signal supply line VDD0, and the drive signal connection lines GOAL may be located between the first power supply signal supply line VDD0 and the second power supply adapt lines VSSZ1. In an exemplary implementation, as shown in FIGS. 5a and 5b, the drive signal connection lines GOAL may be disposed in the second bezel B2, the first conductive layer or the second conductive layer may also be provided with the drive signal lines GOAL0, which may be disposed in the third bezel region B3 and the fourth bezel region B4, and the drive signal connection lines GOAL may electrically connect same types of drive signal lines GOAL0 located in the third bezel region B3 and the fourth bezel region B4 through vias, so as to improve display uniformity.

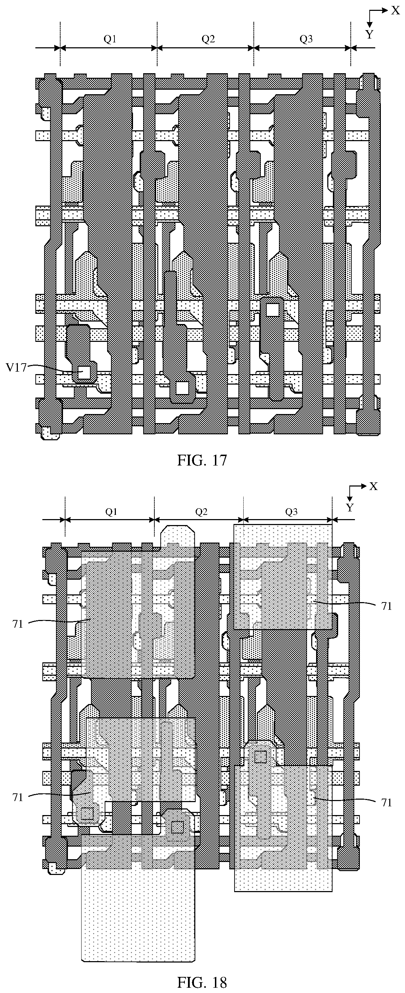

(110) A pattern of a second planarization layer is formed. In an exemplary embodiment, forming the pattern of the second planarization layer may include: coating a second planarization thin film on the base substrate on which the aforementioned patterns are formed, patterning the second planarization thin film by using a patterning process, to form a second planarization layer covering the pattern of the fourth conductive layer, and the second planarization layer is provided with a plurality of vias, as shown in FIG. 17, which is a diagram of a planar structure of three sub-pixels.

In an exemplary implementation, a plurality of vias in each sub-pixel include at least: a seventeenth via V17, second power supply first adapt vias, and second power supply second adapt vias.

In an exemplary implementation, an orthographic projection of the seventeenth via V17 on the base substrate is located within a range of an orthographic projection of a anode connection electrode 63 on the base substrate. The second planarization layer within the seventeenth via V17 is etched away, to expose a surface of the anode connection electrode 63. The second via V17 is configured such that an anode to be formed subsequently is connected to the anode connection electrode 63 through this via.

In an exemplary implementation, as shown in FIG. 8c, orthographic projections of the second power supply first adapt vias on the base substrate are at least partially overlapped with the orthographic projections of the second power supply lines VSS on the base substrate, and the orthographic projections of the second power supply second adapt vias on the base substrate are at least partially overlapped with orthographic projections of the second power supply adapt lines VSSZ1 on the base substrate, so that the second power supply adapt electrodes VSSZ2 to be formed subsequently can be electrically connected to the second power supply lines VSS and the second power supply adapt lines VSSZ1 through the second power supply first adapt vias and the second power supply second adapt vias, respectively.

At this point, manufacturing of a circuit structure layer may be completed. In an exemplary embodiment, after the manufacturing of the circuit structure layer is completed, a light emitting structure layer is manufactured on the circuit structure layer, and the manufacturing process of the light emitting structure layer may include the following operations: forming an anode pattern (i.e., an anode conductive layer), and the anode is connected to the anode connection electrode through an anode via (which may be the seventeenth via V17); a pixel definition layer is formed, and a pixel opening is disposed on the pixel definition layer, the pixel opening exposing an anode; an evaporation or inkjet printing process is used to form an organic light emitting layer, the organic light emitting layer is connected to an anode through a pixel opening, and a cathode is formed on the organic light emitting layer; a encapsulation layer is formed, and the encapsulation layer may include a first encapsulation layer, a second encapsulation layer and a third encapsulation layer stacked, wherein the first encapsulation layer and the third encapsulation layer may be made of an inorganic material, the second encapsulation layer may be made of an organic material, and the second encapsulation layer is disposed between the first encapsulation layer and the third encapsulation layer, so as to ensure that external water vapor cannot enter the light emitting structure layer. The steps of forming the anode conductive layer and the pixel defining layer are as follows:

(111) A pattern of an anode conductive layer is formed. In an exemplary embodiment, forming the anodic conductive layer may include: depositing an anodic conductive thin film on the base substrate on which the aforementioned patterns are formed, patterning the anodic conductive thin film by using a patterning process, to form an anodic conductive layer disposed on a second planarization layer, as shown in FIG. 18, which is a diagram of a planar structure of three sub-pixels.

In an exemplary embodiment, the anode conductive layer includes at least: anodes 71 of a plurality of light emitting elements and second power supply adapt electrodes VSSZ2.

In an exemplary embodiment, a anode 71 may have a substantially rectangular structure, the anode 71 may be connected to the anode connection electrode 63 through the seventeenth via V17, and since the anode connection electrode 63 is connected to the second region 26-2 of the active layer 26 of the sixth transistor T6 (which is also the second region 27-2 of the active layer 27 of the seventh transistor T7) through a via, the anode 71 may be connected to the second region 26-2 of the active layer 26 of the sixth transistor T6 (which is also the second region 27-2 of the active layer 27 of the seventh transistor T7).

In an exemplary embodiment, as shown in FIG. 8c, orthographic projections of the second power supply adapt electrodes VSSZ2 on the base substrate are at least partially overlapped with the orthographic projections of the second power supply lines VSS and the second power supply adapt lines VSSZ1 on the base substrate, and the second power supply adapt electrodes VSSZ2 may be electrically connected to the second power supply lines VSS and the second power supply adapt lines VSSZ1 through the second power supply first adapter vias, the second power supply second adapter vias, respectively.

(112) A pattern of a pixel definition layer is formed. In some examples, a pixel definition layer thin film is coated on the base substrate on which the aforementioned patterns are formed, and a pixel definition layer is formed by masking, exposure, and development processes. The pixel definition layer may be formed with a plurality of pixel openings 81 that expose the anode layer and cathode adapt vias.

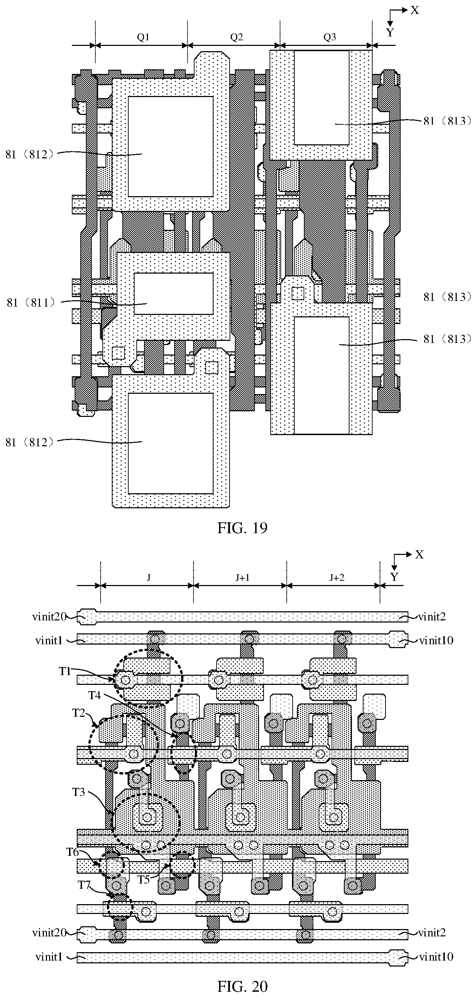

FIG. 19 is a schematic diagram after the pixel defining layer is formed, and an orthographic projection of a pixel opening 81 on the base substrate is within a range of an orthographic projection of a corresponding anode 71 on the base substrate. In an exemplary implementation, a first pixel opening 811 may deposit a luminous material emitting red light, a second pixel opening 812 may deposit a luminous material emitting green light, and a third pixel opening 813 may deposit a luminous material emitting blue light. In other words, the first pixel opening 811 corresponds to a light emitting element emitting red light, the second pixel opening 812 corresponds to a light emitting element emitting green light, and the third pixel opening 813 corresponds to a light emitting element emitting blue light.

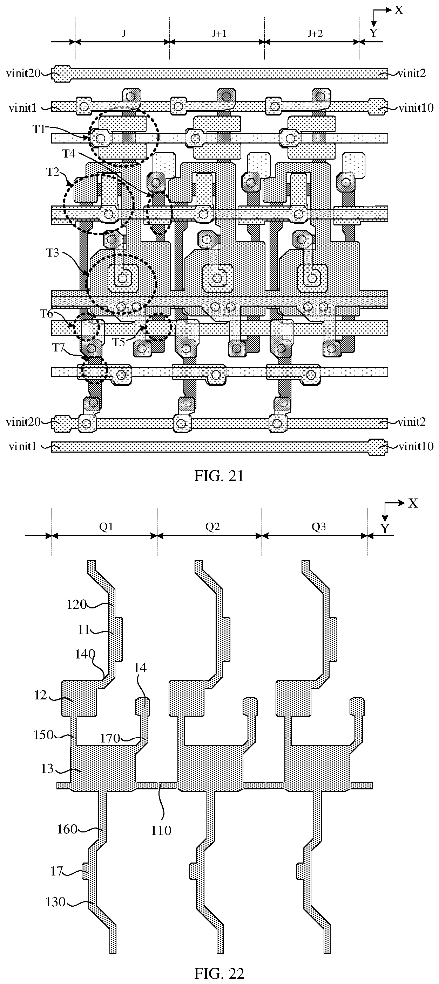

In an exemplary implementation, the first initial signal lines Vinit1 and the second initial signal lines Vinit2 are not limited to the scheme of being disposed on the semiconductor layer, for example, as shown in FIG. 20, the first initial signal lines Vinit1 and the second initial signal lines Vinit2 may be disposed on the third conductive layer; as shown in FIG. 21, the first initial signal lines Vinit1 and the second initial signal lines Vinit2 may be disposed on the second conductive layer.

In an exemplary implementation, as shown in FIG. 8c, orthographic projections of the cathode adapt vias on the base substrate are at least partially overlapped with orthographic projections of the cathode layers and the second power supply adapt electrodes VSSZ2 on the base substrate, such that the cathode layers to be formed subsequently is electrically connected to the second power supply adapt electrodes VSSZ2 through the cathode adapt vias.

In an exemplary implementation, taking 3 sub-pixels (1 sub-pixel rows and 3 sub-pixel columns) in a display area (AA) as an example, another manufacturing process of a display substrate may include following operations.

(201) A substrate is manufactured on a glass carrier plate. The manufacturing method is the same as that in the operation (101) above, and will not be described here.

(202) A pattern of a shield layer is formed. The manufacturing method is the same as that in the operation (102) above, and will not be described here. The formed pattern of the shield layer is shown in FIG. 22. FIG. 22 differs from FIG. 9 in that shapes of a second connection structure 120 and a third connection structure 130 may be shapes of polylines extending in the second direction Y; the fourth shield structure 14 may not be integrally formed with the second shield structures 12.

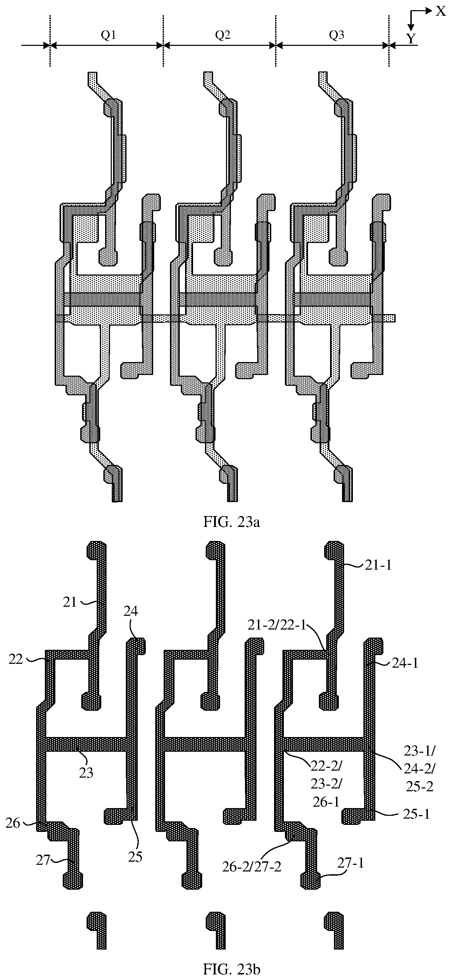

(203) A pattern of a semiconductor layer is formed. The manufacturing method is the same as that in the operation (103) above, and will not be described here. The semiconductor layer formed is shown in FIGS. 23a and 23b. FIG. 23a is a schematic diagram of a structure after the layered semiconductor layer, and FIG. 23b is a schematic diagram of the semiconductor layer in FIG. 23a. The difference between FIGS. 23a and 23b and FIGS. 10a and 10b is that the semiconductor layer is not provided with the first initial signal lines Vinit1 and the second initial signal lines Vinit2; the active layers 23 of the third transistors T3 are provided in a strip structure extending in the first direction X.

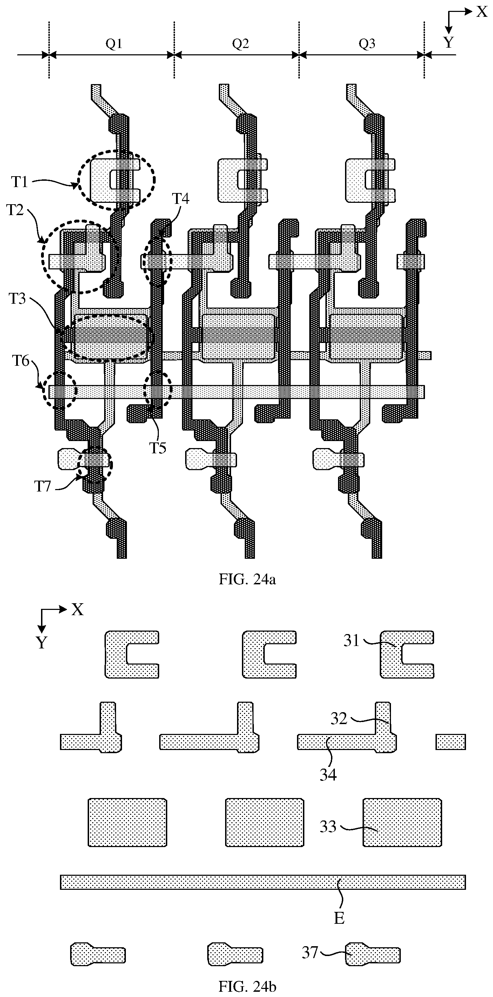

(204) A pattern of a first conductive layer is formed. The manufacturing method is the same as that in the operation (104) above, and will not be described here. The formed semiconductor layer is shown in FIGS. 24a and 24b.

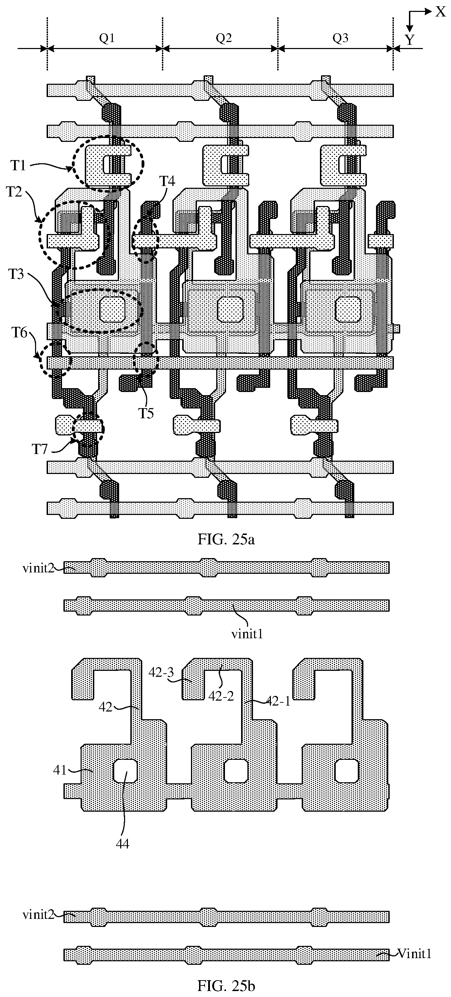

(205) A pattern of a second conductive layer is formed. The manufacturing method is the same as that in the operation (105) above, and will not be described here. The pattern of the second conductive layer formed is shown in FIGS. 25a and 25b. FIG. 25a is a diagram of a planar structure of three sub-pixels, and FIG. 25b is a diagram of a structure of the second conductive layer in FIG. 25a. The difference between FIGS. 25a and 25b and FIGS. 12a and 12b is that the first initial signal lines Vinit1 and the second initial signal lines Vinit2 are newly added. In the second direction Y, the first initial signal lines Vinit1 and the second initial signal lines Vinit2 are located on both sides of the second plate 41. For example, in a same sub-pixel, the first initial signal line Vinit1, the second plate 41, and the second initial signal line Vinit2 may be arranged sequentially in the second direction Y, and the first initial signal line Vinit1 and the second initial signal line Vinit2 may extend in the first direction X.

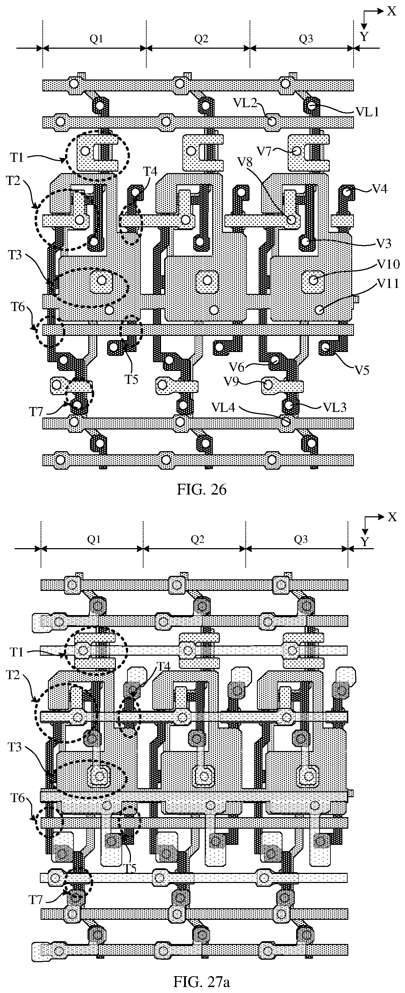

(206) A pattern of a fourth insulation layer is formed. The manufacturing method is the same as that in the operation (106) above, and will not be described here. The pattern of the fourth insulation layer pattern formed is shown in FIG. 26, which is a diagram of a planar structure of three sub-pixels. The difference between FIG. 26 and FIG. 13 is that first connection vias VL1 to fourth connection vias VL2 are newly added. Orthographic projections of the first connection vias VL1 on the base substrate are at least partially overlapped with the orthographic projections of the active layers 21 of the first transistors T1 on the base substrate. Orthographic projections of the second connection vias VL2 on the base substrate are at least partially overlapped with the orthographic projections of the first initial signal lines Vinit1 on the base substrate. Orthographic projections of the third connection vias VL3 on the base substrate are at least partially overlapped with the orthographic projections of the active layers 27 of the seventh transistors T7 on the base substrate. Orthographic projections of the fourth connection vias VL4 on the base substrate are at least partially overlapped with the orthographic projection of the second initial signal lines Vinit2 on the base substrate.

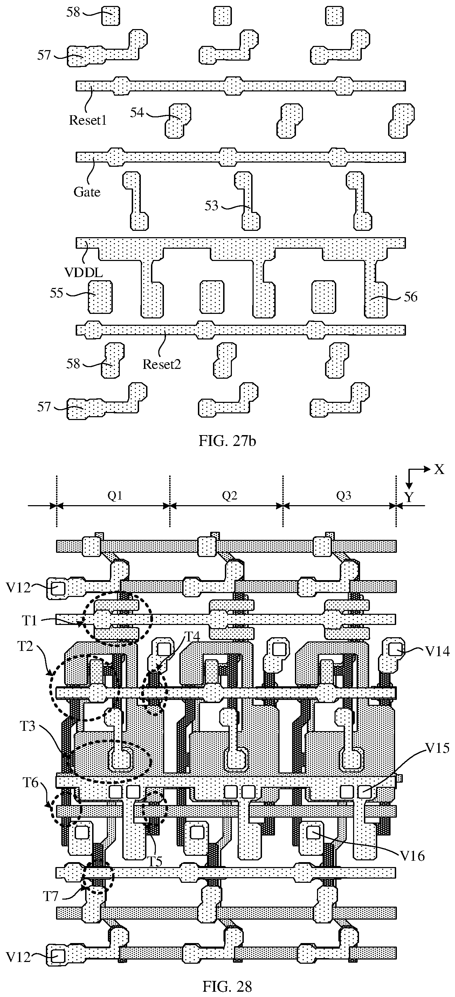

(207) A pattern of a third conductive layer is formed. The manufacturing method is the same as that in the operation (107) above, and will not be described here. The pattern of the third conductive layer formed is shown in FIGS. 27a and 27b. FIG. 27a is a diagram of a planar structure of three sub-pixels, and FIG. 27b is a diagram of a structure of the third conductive layer in FIG. 27a. FIGS. 27a and 27b differ from FIGS. 14a and 14b in that the first connection electrodes 51 and the second connection electrodes 52 are not provided; Seventh connection electrodes 57 and eighth connection electrodes 58 are newly added. Wherein a seventh connection electrode 57 may be in a polyline structure extending in the first direction X, at one end is connected to the first region 21-1 of the active layer 21 of the first transistor T1 through the first connection via VL1, and at the other end is connected to the first initial signal line Vinit1 through the second connection via VL2; an eighth connection electrode 58 may be in a polyline structure extending substantially in the second direction Y, at one end is connected to the first region 27-1 of the active layer 27 of the seventh transistor T7 through the third connection via VL3, and at the other end is connected to the second initial signal line Vinit2 through the fourth connection via VL4.

(208) Patterns of a fifth insulation layer and a first planarization layer are formed. The manufacturing method is the same as that in the operation (108) above, and will not be described here. The patterns of the fifth insulation layer and the first planarization layer formed are shown in FIG. 28, which is a diagram of a planar structure of three sub-pixels. The difference between FIG. 28 and FIG. 15 is that the orthogonal projections of the twelfth vias V12 on the base substrate are at least partially overlapped with orthogonal projections of the seventh connection electrodes 57 on the base substrate, and the orthogonal projections of the thirteenth vias V13 (not shown in FIG. 28) on the base substrate are at least partially overlapped with orthogonal projections of the eighth connection electrodes 58 on the base substrate.

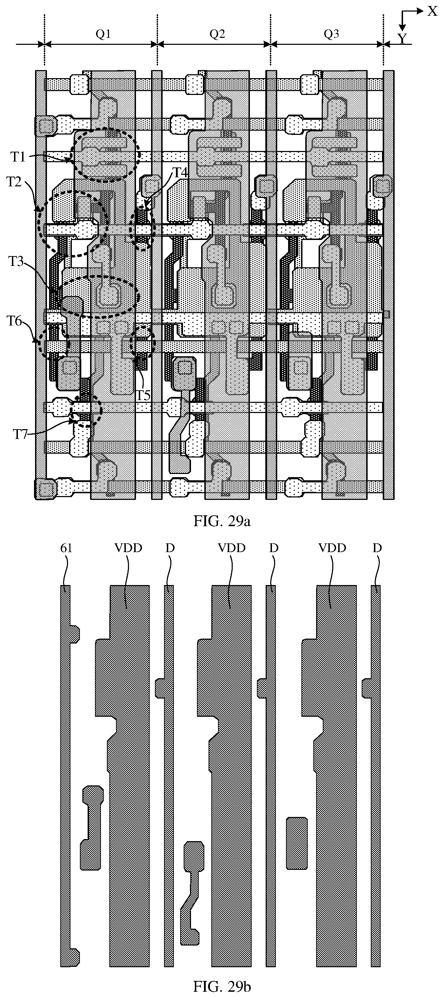

(209) A pattern of a fourth conductive layer is formed. The manufacturing method is the same as that in the operation (108) above, and will not be described here. The pattern of the third conductive layer formed is shown in FIGS. 29a and 29b. FIG. 29a is a diagram of a planar structure of three sub-pixels, and FIG. 29b is a diagram of a structure of the third conductive layer in FIG. 29a.

In an exemplary implementation, after the drive circuit layer is manufactured, a light emitting structure layer is manufactured on the drive circuit layer, and the manufacturing process of the light emitting structure layer may include the following steps: forming a pattern of a second planarization layer, the second planarization layer being provided with at least an anode via; forming a pattern of an anode, the anode being connected to the anode connection electrode through the anode via; An anode pixel definition layer is formed, and the pixel definition layer is provided with a pixel opening exposing the anode. An organic emitting layer is formed using an evaporation or inkjet printing process, and a cathode is formed on the organic emitting layer. An encapsulation layer is formed, the encapsulation layer may include a first encapsulation layer, a second encapsulation layer, and a third encapsulation layer that are stacked, the first encapsulation layer and the third encapsulation layer may be made of an inorganic material, the second encapsulation layer may be made of an organic material, and the second encapsulation layer is disposed between the first encapsulation layer and the third encapsulation layer to ensure that external water vapor cannot enter the light emitting structure layer.

In an exemplary implementation, the subsequent operations of forming the pattern of the second planarization layer, forming the pattern of the anode conductive layer, and forming the pattern of the pixel defining layer may be the same as the above-described steps (110), (111), and (112), respectively, and the embodiments of the present disclosure will not be repeated here in detail.

The structure and preparation process shown in the aforementioned embodiments of the present disclosure are only an exemplary explanation. In an exemplary implementation, the corresponding structure can be changed and the patterning process can be increased or reduced according to actual needs. The display substrate of an embodiment of the present disclosure may be applied to other display devices with a pixel drive circuit, such as a quantum dot display. The present disclosure is not limited herein.

The present disclosure further provides a display device, including the display substrate according to any of the aforementioned embodiments. The display device may be any product or component with a display function, such as a mobile phone, a tablet computer, a television, a display, a laptop computer, a digital photo frame, or a navigator, a vehicle display.

In the display substrate and display device according to the embodiment of the present disclosure, at least one second power supply connection line in the display substrate is located in a display area and extends to opposite sides of the display area, and is electrically connected to a second power supply lines located on at least one side of the display area, so that the voltage drops of the second power supply lines can be reduced, and the second power supply signals at different positions on the second power supply lines can be as consistent as possible, thereby improving the display uniformity.

The drawings of the embodiments of the present disclosure only involve structures involved in the embodiments of the present disclosure, and other structures may refer to a general design.

The embodiments of the present disclosure, that is, features in the embodiments, may be combined with each other to obtain a new embodiment in a situation of no conflicts.

Although the implementations disclosed in the embodiments of the present disclosure are described above, contents are only implementations for facilitating understanding of the embodiments of the present disclosure, but are not intended to limit the embodiments of the present disclosure. Any person skilled in the art to which the embodiments of the present disclosure pertain may make any modifications and variations in forms and details of implementation without departing from the spirit and the scope disclosed in the embodiments of the present disclosure. Nevertheless, the scope of patent protection of the embodiments of the present disclosure shall still be subject to the scope defined by the appended claims.

**Claims**

1. A display substrate comprising a base substrate, and second power supply lines and at least one second power supply connection line disposed on a side of the base substrate, wherein the base substrate comprises a display area and a bezel area, the bezel area is located around the display area on a plane parallel to the display substrate, and the second power supply lines are disposed in the bezel area and at least on opposite sides of the display area; the at least one second power supply connection line is located in the display area and extends to the opposite sides of the display area, and is electrically connected to a second power supply line located on at least one side of the display area.

2. The display substrate according to claim 1, further comprising second power supply adapt electrodes and second power supply adapt lines located in the bezel area, wherein on the plane parallel to the display substrate, the second power supply adapt lines are located between the display area and the second power supply lines, the at least one second power supply connection lines is connected to the second power supply adapt lines, and in a direction perpendicular to the plane on which the display substrate is located, the second power supply adapt electrodes are located on a side of the at least one second power supply connection line and the second power supply lines away from the base substrate, the second power supply lines and the second power supply adapt lines are electrically connected through the second power supply adapt electrodes.

3. The display substrate according to claim 2, wherein orthographic projections of the second power supply adapt electrodes on the base substrate are at least partially overlapped with orthographic projections of the second power supply adapt lines and the second power supply lines on the base substrate, and the second power supply adapt electrodes are electrically connected to the second power supply lines and the second power supply adapt lines through vias, respectively.

4. The display substrate according to claim 2, wherein the bezel area comprises a first bezel region and a second bezel region located on two sides of the display area in a second direction, and a third bezel region and a fourth bezel region located on two sides of the display area in a first direction, wherein the second bezel region is provided with at least one drive signal connection line, the third bezel region and the fourth bezel region are respectively provided with at least one type of drive signal line, and drive signal lines of a same type located in the third bezel region and the fourth bezel region are electrically connected through one of the at least one drive signal connection line, and on the plane parallel to the display substrate, the at least one drive signal connection line is located between the second power supply lines and the second power supply adapt lines, the drive signal lines are located between the second power supply lines and the display area, and the first direction intersects with the second direction.

5. The display substrate according to claim 4, wherein the bezel area further comprises a bonding region, and on the plane parallel to the display substrate, the bonding region is located on one side of the display area, the second power supply lines are at least located in the bonding region and on a side of the display area away from the bonding region, and the at least one second power supply connection line extends in a direction from the bonding region to the display area; the bonding region is located in the first bezel region, and the second power supply adapt electrodes and the second power supply adapt lines are located in the first bezel region and the second bezel region.

6. The display substrate according to claim 4, further comprising a first power supply signal supply line disposed in the bezel area and located around the display area in a direction parallel to the plane on which the display substrate is located, and in the first bezel region or the second bezel region, the first power supply signal supply line is located between the second power supply adapt lines and the display area, and in the third bezel region or the fourth bezel region, the first power supply signal supply line is located between the drive signal lines and the display area.

7. The display substrate according to claim 6, further comprising a plurality of first power supply connection lines and a plurality of first power supply lines located in the display area, wherein the display area is further provided with a plurality of sub-pixels arranged in an array, the plurality of first power supply connection lines extend in the first direction and are arranged at intervals in the second direction, and the plurality of first power supply lines extend in the second direction and are arranged at intervals in the first direction;
two ends of the first power supply connection lines are electrically connected to the first power supply signal supply line located in the third bezel region and the fourth bezel region, respectively, and middle parts of the first power supply connection lines are electrically connected to at least one row of sub-pixels; in the direction perpendicular to the plane on which the display substrate is located, the first power supply lines are located on a side of the first power supply connection lines and the first power supply signal supply line away from the base substrate, middle parts of the first power supply lines are electrically connected to the plurality of first power supply lines, and two ends of the first power supply lines are electrically connected to the first power supply signal supply line located in the first bezel region and the second bezel region, respectively.

8. The display substrate according to claim 6, wherein in the second direction, a size of the first power supply signal supply line and a size of a second power supply line are both larger than a size of a second power supply adapt line.

9. The display substrate according to any one of claims 4 to 8, further comprising an anode conductive layer and a cathode layer, wherein in the direction perpendicular to the plane on which the display substrate is located, the cathode layer is located on a side of the anode conductive layer away from the base substrate; the second power supply adapt electrodes are located in the anode conductive layer, and orthographic projections of the second power supply adapt electrodes on the base substrate are at least partially overlapped with an orthographic projection of the cathode layer on the base substrate, and the second power supply adapt electrodes are electrically connected to the cathode layer.

10. The display substrate according to claim 1, wherein a quantity of the at least one second power supply connection line is a plurality, the display area comprises a plurality of sub-pixels arranged in an array, the plurality of second power supply connection lines are arranged in a row direction and extend in a column direction, at least one of the second power supply connection lines is disposed between two adjacent columns of sub-pixels, and the row direction intersects with the column direction on the plane parallel to the display substrate.

11. The display substrate according to claim 10, wherein the display area further comprises a plurality of initial signal lines and a plurality of initial signal connection lines, the plurality of initial signal lines are configured to be electrically connected to a plurality of rows of sub-pixels respectively, and the initial signal connection lines are configured to be electrically connected to at least some of the initial signal lines; in a direction parallel to the plane on which the display substrate is located, the plurality of initial signal lines extend in the row direction and are arranged at intervals in the column direction, and the plurality of initial signal connection lines extend in the column direction and are arranged at intervals in the row direction, and in a direction perpendicular to the plane on which the display substrate is located, the plurality of initial signal connection lines and the plurality of initial signal lines are located in different conductive layers.

12. The display substrate according to claim 11, wherein the plurality of initial signal lines comprise a plurality of first initial signal lines and a plurality of second initial signal lines, and at least some of the sub-pixels comprise a plurality of transistors, the plurality of transistors comprise at least first transistors and seventh transistors; the plurality of first initial signal lines are configured to be electrically connected to first transistors in the plurality of rows of sub-pixels respectively, and the plurality of second initial signal lines are configured to be electrically connected to seventh transistors in the plurality of rows of sub-pixels respectively; and
the plurality of initial signal connection lines comprise a plurality of first initial signal connection lines and a plurality of second initial signal connection lines; the first initial signal connection lines are configured to be electrically connected to the plurality of first initial signal lines, and the second initial signal connection lines are configured to be electrically connected to the plurality of second initial signal lines.

13. The display substrate according to claim 12, wherein the display substrate comprises a semiconductor layer, a second conductive layer, a third conductive layer, and a fourth conductive layer sequentially disposed on the base substrate in the direction perpendicular to the plane on which the display substrate is located, and the plurality of initial signal lines are disposed in one of the semiconductor layer, the second conductive layer, and the third conductive layer; and the plurality of initial signal connection lines are disposed in the fourth conductive layer.

14. The display substrate according to claim 12, wherein the plurality of sub-pixels form a plurality of pixel units arranged in an array, at least some of the pixel units comprise at least three sub-pixels sequentially arranged in the row direction, and a second power supply connection line, a first initial signal line, and a second initial signal line are disposed between two adjacent columns of pixel units.

15. The display substrate according to any one of claims 2 to 8 and 11 to 14, further comprising a shield layer and a circuit structure layer disposed on the base substrate, and the shield layer is located between the base substrate and the circuit structure layer in the direction perpendicular to the plane on which the display substrate is located.

16. The display substrate according to claim 15, wherein the display area is provided with a plurality of sub-pixels, at least some of the sub-pixels comprise first transistors to seventh transistors in the circuit structure layer and at least one shield structure in the shield layer, and each shield structure is disposed to shield a channel region of at least one of a first transistor to a seventh transistor in a same sub-pixel.

17. The display substrate according to claim 16, wherein in the same sub-pixel, the shield layer comprises one or more of a first shield structure to a seventh shield structure, an orthographic projection of the first shield structure on the base substrate is at least partially overlapped with an orthographic projection of the first transistor on the base substrate; an orthographic projection of a second shield structure on the base substrate is at least partially overlapped with an orthographic projection of a second transistor on the base substrate; an orthographic projection of a third shield structure on the base substrate is at least partially overlapped with an orthographic projection of a third transistor on the base substrate; an orthographic projection of a fourth shield structure on the base substrate is at least partially overlapped with an orthographic projection of a fourth transistor on the base substrate; an orthographic projection of a fifth shield structure on the base substrate is at least partially overlapped with an orthographic projection of a fifth transistor on the base substrate; an orthographic projection of a sixth shield structure on the base substrate is at least partially overlapped with an orthographic projection of a sixth transistor on the base substrate; and an orthographic projection of the seventh shield structure on the base substrate is at least partially overlapped with an orthographic projection of the seventh transistor on the base substrate.

18. The display substrate according to claim 17, wherein the plurality of sub-pixels form a plurality of sub-pixel rows, the shield layer comprises second shield structures and fourth shield structures, and in a same sub-pixel row, a second shield structure located in one sub-pixel and a fourth shield structure located in an adjacent sub-pixel are formed into an integral structure.

19. The display substrate according to claim 17, wherein the plurality of sub-pixels form a plurality of sub-pixel rows, the shield layer comprises third shield structures, and in a same sub-pixel row and in a row direction, a distance between two third shield structures located in two adjacent sub-pixels is greater than a size of a channel region of a fourth transistor.

20. The display substrate according to claim 16, further comprising a first power supply signal supply line, wherein the first power supply signal supply line is disposed in the bezel area and located around the display area, and in the direction perpendicular to the plane on which the display substrate is located, the first power supply signal supply line is located on a side of the shield layer away from the base substrate, and shield layers of a plurality of sub-pixels located on a side of the display area close to the bezel area are electrically connected to the first power supply signal supply line.

21. The display substrate according to claim 20, further comprising shield adapt lines located at least on two sides of a group of opposite sides of the display area, and on the plane parallel to the display substrate, the shield adapt lines are located between the second power supply lines and the display area, the shield layers of a plurality of sub-pixels located on the side of the display area close to the bezel area are connected to the shield adapt lines, the first power supply signal supply line is electrically connected to the shield adapt lines through vias, and an orthographic projection of the first power supply signal supply line on the base substrate is at least partially overlapped with orthographic projections of the shield adapt lines on the base substrate.

22. A display device, comprising the display substrate according to any one of claims 1 to 21.

FIG. 1

FIG. 2

FIG. 3

FIG. 4

FIG. 5a

FIG. 5b

FIG. 5c

FIG. 5d

FIG.6a

FIG. 6b

FIG. 6c

FIG. 6d

FIG. 7a

FIG. 7b

FIG. 7c

FIG. 7d

FIG. 7e

FIG. 8a

FIG. 8b

FIG. 8c

FIG. 9

FIG. 10a

FIG. 10b

FIG. 10c

FIG. 11a

FIG. 11b

FIG. 12a

FIG. 12b

FIG. 13

FIG. 14a

FIG. 14b

FIG. 14c

FIG. 15

FIG. 16a

61  VDD  D  VDD  D  VDD  D  62

63

63

63

FIG. 16b

N1  N2  N3

T1
T4
T2

T3

T6
T7  T5

FIG. 16c

FIG. 16d

FIG. 16e

EP 4 642 204 A1

X
Y

Q1 Q2 Q3

V17

FIG. 17

X
Y

Q1 Q2 Q3

71

71

71

71

FIG. 18

FIG. 19

FIG. 20

EP 4 642 204 A1

FIG. 21

FIG. 22

57

FIG. 23a

FIG. 23b

FIG. 24a

FIG. 24b

FIG. 25a

FIG. 25b

FIG. 26

FIG. 27a

FIG. 27b

FIG. 28

**EP 4 642 204 A1**

FIG. 29a

FIG. 29b

63

INTERNATIONAL SEARCH REPORT

International application No.

PCT/CN2023/121714

### A. CLASSIFICATION OF SUBJECT MATTER

H10K 59/131(2023.01)i

According to International Patent Classification (IPC) or to both national classification and IPC

### B. FIELDS SEARCHED

Minimum documentation searched (classification system followed by classification symbols)

IPC: H01L,H10K

Documentation searched other than minimum documentation to the extent that such documents are included in the fields searched

Electronic data base consulted during the international search (name of data base and, where practicable, search terms used)

CNTXT, ENTXTC, ENTXT, DWPI, CNKI, IEEE: 显示, 基板, 电源, 线, 边框, 外围, 周边, 非显示, display, substrate, power, supply, line, wire, frame, peripheral, non-display

### C. DOCUMENTS CONSIDERED TO BE RELEVANT

| Category* | Citation of document, with indication, where appropriate, of the relevant passages | Relevant to claim No. |
|---|---|---|
| X | CN 114122025 A (BOE TECHNOLOGY GROUP CO., LTD. et al.) 01 March 2022 (2022-03-01) description, paragraphs 58-156, and figures 1-12 | 1, 22 |
| Y | CN 114122025 A (BOE TECHNOLOGY GROUP CO., LTD. et al.) 01 March 2022 (2022-03-01) description, paragraphs 58-156, and figures 1-12 | 2-22 |
| Y | CN 115768205 A (BOE TECHNOLOGY GROUP CO., LTD. et al.) 07 March 2023 (2023-03-07) description, paragraphs 45-75, and figures 1-11 | 2-22 |
| A | CN 113471268 A (HEFEI BOE JOINT TECHNOLOGY CO., LTD. et al.) 01 October 2021 (2021-10-01) entire document | 1-22 |
| A | CN 116234385 A (HEFEI BOE JOINT TECHNOLOGY CO., LTD. et al.) 06 June 2023 (2023-06-06) entire document | 1-22 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 16 April 2024 | 18 April 2024 |

| Name and mailing address of the ISA/CN | Authorized officer |
|---|---|
| China National Intellectual Property Administration (ISA/CN) China No. 6, Xitucheng Road, Jimenqiao, Haidian District, Beijing 100088 | |
| | Telephone No. |

Form PCT/ISA/210 (second sheet) (July 2022)

**INTERNATIONAL SEARCH REPORT**

| International application No. |
| --- |
| **PCT/CN2023/121714** |

| C. | DOCUMENTS CONSIDERED TO BE RELEVANT | |
| --- | --- | --- |
| Category* | Citation of document, with indication, where appropriate, of the relevant passages | Relevant to claim No. |
| A | KR 20170109118 A (SAMSUNG DISPLAY CO., LTD.) 28 September 2017 (2017-09-28) entire document | 1-22 |

Form PCT/ISA/210 (second sheet) (July 2022)

**INTERNATIONAL SEARCH REPORT**
Information on patent family members

International application No.

**PCT/CN2023/121714**

| Patent document cited in search report | | | Publication date (day/month/year) | Patent family member(s) | | | Publication date (day/month/year) |
|---|---|---|---|---|---|---|---|
| CN | 114122025 | A | 01 March 2022 | None | | | |
| CN | 115768205 | A | 07 March 2023 | None | | | |
| CN | 113471268 | A | 01 October 2021 | None | | | |
| CN | 116234385 | A | 06 June 2023 | None | | | |
| KR | 20170109118 | A | 28 September 2017 | KR | 102493129 | B1 | 31 January 2023 |

Form PCT/ISA/210 (patent family annex) (July 2022)